# EUROPEAN PATENT APPLICATION

(11) **EP 4 365 679 A1**
(43) Date of publication of application: **08.05.2024**
(21) Application number: 22832735.9
(22) Date of filing: 07.06.2022
(51) Int. Cl.: G03F 7/16, G03F 7/004, G03F 7/075, G03F 7/09, H01L 21/312

(54) **LAYERED BODY, METHOD FOR MANUFACTURING LAYERED BODY, AND METHOD FOR FORMING PATTERN**

(30) Priority: 30.06.2021 JP 2021109457
(71) Applicant: SHIN-ETSU CHEMICAL CO., LTD., Tokyo 1000005 (JP)
(72) Inventor: HAYASHI, Kumiko, Annaka-shi, Gunma 379-0224 (JP); MARUYAMA, Hitoshi, Annaka-shi, Gunma 379-0224 (JP)
(74) Representative: Sonnenhauser, Thomas Martin
(86) International application number: PCT/JP2022/022906
(87) International publication number: WO 2023/276578

(57) **Abstract**

The present invention relates a laminate including a semiconductor substrate and a photosensitive resin layer formed on the semiconductor substrate. The photosensitive resin layer contains resin having a silicone skeleton or acrylic resin. The semiconductor substrate has a stepped surface on one side. A recessed portion formed by the stepped surface is filled with a pre-wetting solvent, and the photosensitive resin layer is formed thereon. Based on the present invention, the recessed portion formed by the stepped surface on the stepped substrate is filled fully with the photosensitive composition containing the resin having silicone skeleton or the acrylic resin, and the laminate can provide the flat photosensitive resin film. Further, the present invention provides a method for manufacturing the laminate with less material loss and a patterning method using the laminate.

## Description

### TECHNICAL FIELD

The present invention relates to a laminate, a method for manufacturing the laminate, and a method for patterning using the laminate.

### BACKGROUND ART

With the demand for highly integrated semiconductor packages, a through silicon electrode (TSV) technology, which can pass vertically through a substrate or a die and make electrical connections, are used for a 3D package to stack multiple semiconductor packages in a semiconductor package. When forming a wiring layer for TSVs, a SiO₂ film is used as an insulating layer. This is formed by CVD, but it becomes more difficult to form a flat film as a TSV is deeper. In order to use a polished thin wafer for achievement of even higher integration, a resin adhesive was required to attach a support wafer supporting the polished thin wafer, and CVD had to be performed at a low temperature of around 200°C.

Therefore, insulation layers using resin material is proposed. Examples of the formation method can include a printing method, a spray method (Patent Document 1), an inkjet method (Patent Document 2), a spin-coating method, a dip-coating method, and a lamination method. Among them, there is also a method to form a film of an insulation layer only on the side wall by opening VIA by exposure after embedding TSV once using photocurable resin. This method requires embedding resin in TSV without any gaps, and further it is necessary to form a coating film having a flat thickness on a substrate.

The present inventors focus a spin-coating method which is widely used. A spin-coating method uses rotational centrifugal force, and can form a flat coating film by spinning after dropping a coating material onto the center of a wafer. However, because it is generally used for a flat substrate and is applied with rotating, the amount of a coating material that actually remains on the substrate is smaller than the amount of a coating material that is dropped, and material loss is an issue (Patent Document 3).

### CITATION LIST

### PATENT LITERATURE

Patent Document 1: JP 2010-114201 A
Patent Document 2: JP 2020-134715 A
Patent Document 3: JP 2015-088650 A

### SUMMARY OF INVENTION

### TECHNICAL PROBLEM

The present invention has been made in view of the above-described problem, and provides a laminate which can give a flat photosensitive resin film because a recessed portion formed by a stepped surface of a stepped substrate is fully filled with photosensitive composition containing resin having a silicone skeleton or acrylic resin, a method for manufacturing a laminate, which can embed pre-wetting solvent by spin-coating on a stepped surface formed on one side of a semiconductor substrate with less material loss and form a flat photosensitive resin layer, and a patterning method for the laminate.

### SOLUTION TO PROBLEM

To achieve the object, the present invention provides a laminate comprising: a semiconductor substrate; and a photosensitive resin layer formed on the semiconductor substrate, wherein the photosensitive resin layer comprises resin having a silicone skeleton or acrylic resin, the semiconductor substrate has a stepped surface on one side, a recessed portion formed by the stepped surface is filled with a pre-wetting solvent, and the photosensitive resin layer is formed thereon.

In such a laminate, because the recessed portion formed by the stepped surface on the stepped substrate is filled fully with the photosensitive composition containing the resin having silicone skeleton or the acrylic resin, the laminate can provide the flat photosensitive resin film.

In this event, an opening of the stepped surface preferably has a width of 10 to 100 um and a depth of 10 to 120 µm.

Even if a laminate has such a stepped surface, a recessed portion formed by the stepped surface on the stepped substrate can be filled fully with the photosensitive composition containing the resin having silicone skeleton or the acrylic resin.

In this event, the pre-wetting solvent is preferably a solvent of one kind or a mixed solvent containing a solvent having a boiling point of 130°C or higher at least 30 mass%.

In such a laminate, because the recessed portion formed by the stepped surface on the stepped substrate is filled further fully with the resin, the laminate can provide a flatter photosensitive resin film.

In this event, the photosensitive resin layer preferably contains (A) a polymer having a silicone skeleton, (B) a photo-acid generator which is decomposed by a light of 190 to 500 nm and generates an acid, and (C) a solvent.

In such a laminate, the recessed portion formed by the stepped surface of the semiconductor substrate can be embedded well finally.

In this event, the polymer (A) having a silicone skeleton preferably includes at least one repeating unit represented by any of the following formulae (a1) to (a4) and at least one repeating unit represented by any of the following formulae (b1) to (b4), 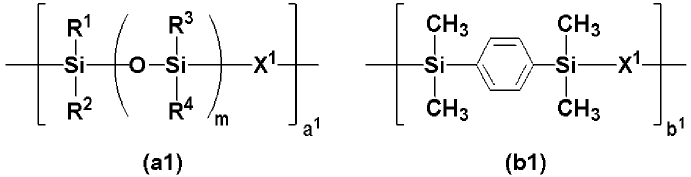 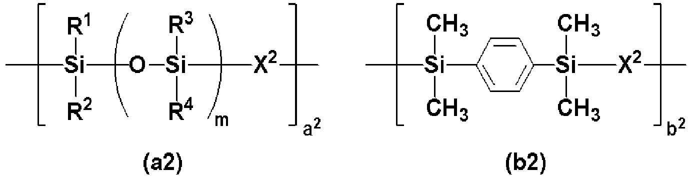 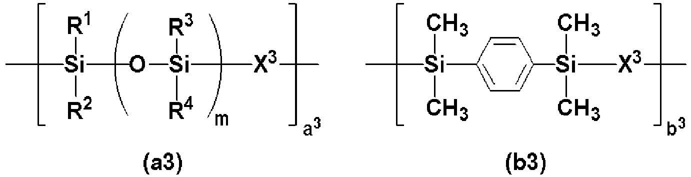 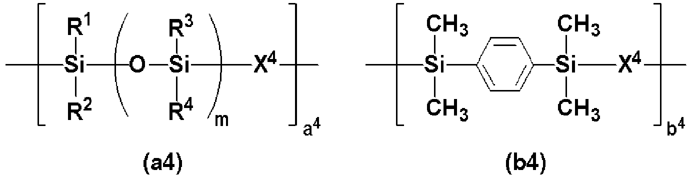 wherein, R¹ to R⁴ each independently represent a monovalent hydrocarbon group having 1 to 8 carbon atoms; "m" represents an integer of 1 to 600; a¹ to a⁴ and b¹ to b⁴ are values satisfying, 0≤a¹<1, 0≤a²<1, 0≤a³<1, 0≤a⁴<1, 0≤b¹<1, 0≤b²<1, 0≤b³<1, 0≤b⁴<1, 0<a¹+a²+a³+a⁴<1, 0<b²+b²+b³+b⁴<1, and a¹+a²+a³+a⁴+b¹+b²+b³+b⁴=1; X¹ is a divalent group represented by the following formula (X1); X² is a divalent group represented by the following formula (X2); X³ is a divalent group represented by the following formula (X3); X⁴ is a divalent group represented by the following formula (X4), 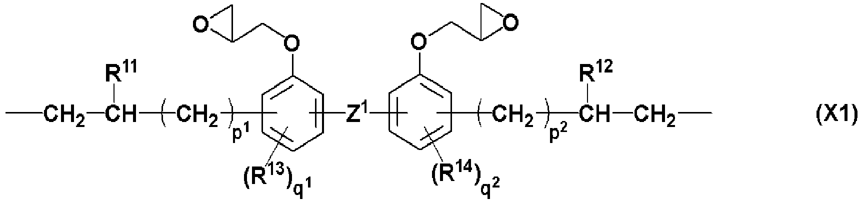 wherein, Z¹ represents a single bond, a methylene group, a propane-2,2-diyl group, a 1,1,1,3,3,3-hexafluoropropane-2,2-diyl group, or a fluorene-9,9-diyl group; R¹¹ and R¹² each independently represent a hydrogen atom or a methyl group; R¹³ and R¹⁴ each independently represent an alkyl group having 1 to 4 carbon atoms, or an alkoxy group having 1 to 4 carbon atoms; p¹ and p² each independently represent an integer of 0 to 7; q¹ and q² are each independently an integer of 0 to 2, 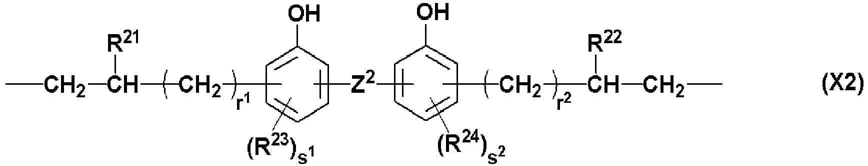 wherein, Z² represents a single bond, a methylene group, a propane-2,2-diyl group, a 1,1,1,3,3,3-hexafluoropropane-2,2-diyl group, or a fluorene-9,9-diyl group; R²¹ and R²² each independently represent a hydrogen atom or a methyl group; R²³ and R²⁴ each independently represent an alkyl group having 1 to 4 carbon atoms, or an alkoxy group having 1 to 4 carbon atoms; r¹ and r² each independently represent an integer of 0 to 7; s¹ and s² each independently represent an integer of 0 to 2, 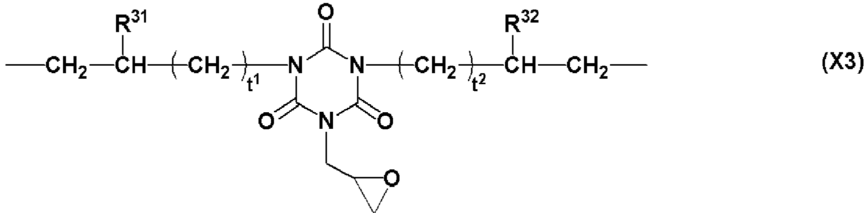 wherein, R³¹ and R³² each independently represent a hydrogen atom or a methyl group; t¹ and t² each independently represent an integer of 0 to 7, 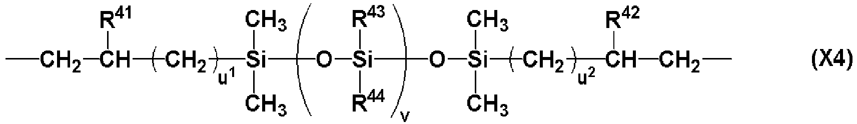 wherein, R⁴¹ and R⁴² each independently represent a hydrogen atom or a methyl group; R⁴³ and R⁴⁴ each independently represent a monovalent hydrocarbon group having 1 to 8 carbon atoms; u¹ and u² each independently represent an integer of 0 to 7; "v" represents an integer of 0 to 600.

In such a component (A), the recessed portion formed by the stepped surface of the semiconductor substrate can be embedded better finally.

Further, in the present invention, the photosensitive resin layer preferably contains (A') an acrylic polymer, (B') a photopolymerization initiator, and (C) a solvent also.

Even in such a component (A') and (B'), the recessed portion formed by the stepped surface of the semiconductor substrate can be embedded well finally.

Further the present invention provides a method for manufacturing the laminate, the method including: a first coating step of pre-wetting a recessed portion formed by the stepped surface of the semiconductor substrate having the stepped surface on one side with a pre-wetting solvent by spin-coating, and filling the recessed portion of the stepped surface with the pre-wetting solvent; a scraping step of scraping off any excess pre-wetting solvent pre-wetted on the semiconductor substrate, with spinning; and a second coating step of spin-coating a surface filled with the pre-wetting solvent by spin coating, with photosensitive resin composition containing resin having silicone skeleton or acrylic resin, to form a photosensitive resin layer, being coating film of the photosensitive resin composition.

By such a method for manufacturing the laminate, it is possible, with use of photosensitive composition containing resin having a silicone skeleton or acrylic resin, to embed pre-wetting solvent by spin-coating on a stepped surface formed on one side of a semiconductor substrate with less material loss, and manufacture a laminate which can form the flat photosensitive resin layer.

In this event, the second coating step is preferably performed without stopping a rotation of the semiconductor substrate from the scraping step.

By such a method for manufacturing a laminate, the photosensitive resin component can be drop without drying of the wafer surface, and filling of the stepped surface of the semiconductor substrate can be performed well.

In this event, a solvent of one kind or mixed solvents which contain a solvent having a boiling point of 130°C or higher at least 30 mass% is preferably used as a pre-wetting solvent used in the first coating step.

By such a method for manufacturing a laminate, containing a solvent having high boiling point prevents a surface of a semiconductor substrate from being dried in pre-wetting, dropping photosensitive resin composition to form photosensitive resin layer, etc., and it becomes easy to spread coating.

Further, the present invention provides the patterning method including: curing the photosensitive resin layer by pre-heating to form a photosensitive resin film; exposing the photosensitive resin film through a photomask; and developing with a developing solution and removing an unexposed part by dissolving after heating after exposing, to form a pattern.

By such a patterning method, photosensitive resin including resin having the silicone skeleton or the acrylic resin can be embedded well on the stepped surface of the substrate, and a flat photosensitive resin film is formed. Therefore, it is possible to form an insulation layer only on the side wall by opening VIA by exposure (forming a pattern).

### ADVANTAGEOUS EFFECTS OF INVENTION

According to the inventive method for manufacturing a laminate, by using a photosensitive resin composition containing resin having a silicone skeleton or acrylic resin, a level difference on a semiconductor substrate can filled with less amount of coating solution snugly with high filling rate, and a photosensitive resin layer can be formed in a flat film on a semiconductor substrate.

### BRIEF DESCRIPTION OF DRAWINGS

FIG. 1 is a schematic view showing an example of an inventive laminate.
FIG. 2 is a schematic view showing an example of a method for manufacturing the inventive laminate.
FIG. 3 shows conditions for spin-coating in the first coating step, the scraping step, and the second coating step.

### DESCRIPTION OF EMBODIMENTS

As noted above, it has been desired to develop: a laminate of which a stepped surface on one side of a semiconductor substrate can be filled with photosensitive composition containing resin having a silicone skeleton or acrylic resin, with less material loss, by spin-coating, and can be formed to be a flat film; a method for manufacturing the laminate; and a method for patterning.

The present inventors have earnestly studied to achieve the above objective, and found: by pre-wetting a recessed portion formed by a stepped surface of a semiconductor substrate having the stepped surface on one side with a pre-wetting solvent and then coating a photosensitive resin composition containing resin having a silicone skeleton or acrylic resin, the photosensitive resin composition can be coated in a small amount, and the recessed portion formed by a stepped surface of a semiconductor substrate having a stepped surface on one side can be filled snugly with a small amount of photosensitive resin compound; the recessed portion formed by the stepped surface of the obtained laminate can be filled without any gaps; and a flat film can be formed on a semiconductor substrate. The above finding is made to the present invention.

That is, the present invention relates to a laminate including: a semiconductor substrate; and a photosensitive resin layer formed on the semiconductor substrate, wherein the photosensitive resin layer contains resin having a silicone skeleton or acrylic resin, the semiconductor substrate has a stepped surface on one side, a recessed portion formed by the stepped surface is filled with a pre-wetting solvent, and the photosensitive resin layer is formed thereon.

Hereinafter, the present invention will be described in detail, but the present invention is not limited thereto.

### [Laminate]

The inventive laminate includes a semiconductor substrate and a photosensitive resin layer formed on the semiconductor substrate. The photosensitive resin layer contains resin having a silicone skeleton or acrylic resin. The semiconductor substrate has a stepped surface on one side, a recessed portion formed by the stepped surface is filled with a pre-wetting solvent, and the photosensitive resin layer is formed thereon.

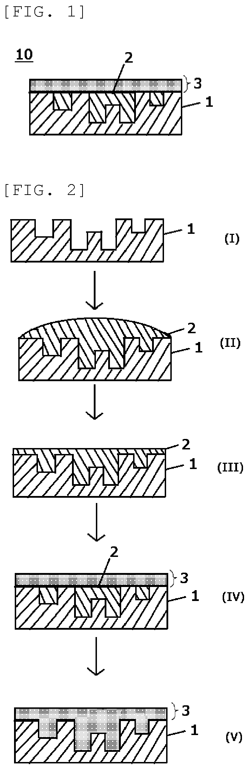

As shown FIG. 1, the inventive laminate 10 is formed with a semiconductor substrate 1, a photosensitive resin layer 3 formed on a semiconductor substrate 1. The semiconductor substrate 1 has a stepped surface on one side. A recessed portion formed by a stepped surface is filled with a pre-wetting solvent 2, and a photosensitive resin layer 3 is formed on the pre-wetting solvent 2.

In this event, a width of opening of the stepped surface is preferably 10 to 100 µm, more preferably 50 to 80 µm, and its depth is preferably 10 to 120 µm, more preferably 50 to 100 µm.

### [Method for Manufacturing a Laminate]

As the method for the inventive laminate, examples include a method having: a first coating step of pre-wetting a recessed portion formed by a stepped surface of a semiconductor substrate having the stepped surface on one side with a pre-wetting solvent by spin-coating, and filling the recessed portion of the stepped surface with the pre-wetting solvent; a scraping step of scraping off any excess pre-wetting solvent pre-wetted on the semiconductor substrate, with spinning; and a second coating step of spin-coating a surface filled with the pre-wetting solvent by spin coating, with photosensitive resin composition containing resin having silicone skeleton or acrylic resin, to form a photosensitive resin layer, being coating film of the photosensitive resin composition.

Hereinafter, the method for manufacturing the laminate will be described in detail with referring FIG. 2.

FIG. 2 shows an example of methods for manufacturing the inventive laminate. First, a semiconductor substrate 1 having a stepped surface on one side is prepared (FIG. 2 (I)). Next, a first coating step is performed (FIG. 2 (II)), wherein a recessed portion formed by the stepped surface of the semiconductor substrate 1 having the stepped surface on one side is pre-wetted with a pre-wetting solvent 2 by spin-coating, and filled with the pre-wetting solvent 2. Next, a scraping step (FIG. 2 (III)) is performed, wherein any excess pre-wetting solvent 2 on the semiconductor substrate 1 is scraped off with spinning. Next, a second coating step (FIG. 2 (IV)) is performed to obtain a laminate 10, wherein photosensitive resin composition containing resin having a silicone skeleton or acrylic resin is spin-coated on a surface filled with the pre-wetting solvent 2 by spin coating, with photosensitive resin composition containing resin having a silicone skeleton or acrylic resin, to form a photosensitive resin layer 3, which is a coating film of the photosensitive resin composition.

The obtained laminate 10 is rotated further so that a thickness of the photosensitive resin layer 3 should be the desired film thickness. During this, the pre-wetting solvent 2 is replaced with the photosensitive resin composition, the photosensitive resin composition is embedded into the semiconductor substrate 1 without any gaps, and the inventive laminate 10 is obtained (FIG. 2 (V)).

Hereinafter, each step will be described in detail.

### (First Coating Step) pre-wet

The first coating step is a step where the recessed portion formed by the stepped surface of the semiconductor substrate 1 having the stepped surface on one side is pre-wetted and filled with the pre-wetting solvent 2 by spin-coating.

In the case of the semiconductor substrate 1 having the stepped surface with level differences such as TSV on one surface, it is difficult generally to coat and fill the entire recessed portion formed by the stepped surface with the photosensitive resin composition in a liquid state as it is because such composition does not pervade the entire recessed portion formed by the stepped surface. Therefore, pre-wetting, which is filling the recessed portion formed by the stepped surface with pre-wetting solvent 2 in advance, makes it easy for a photosensitive resin composition coated afterward to pervade and being embedded.

Such a pre-wetting solvent 2 is preferably an organic solvent, and may be used solely or in combination of two or more kinds.

Such a pre-wetting solvent 2, for example, can include: ketones such as cyclohexanone, cyclopentanone, methyl-2-n-amyl ketone, etc.; alcohols such as 3-methoxybutanol, 3-methyl-3-methoxybutanol, 1-methoxy-2-propanol, 1-ethoxy-2-propanol, etc.; ethers such as propylene glycol monomethyl ether, ethylene glycol monomethyl ether, propylene glycol monoethyl ether, ethylene glycol monoethyl ether, propylene glycol dimethyl ether, diethylene glycol dimethyl ether, etc.; esters such as propylene glycol monomethyl ether acetate, propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, propylene glycol mono-tert-butyl ether acetate, γ-butyrolactone, etc.

Among them, in the present embodiment, the closer polarity and solubility parameters are to those of a solvent (will be mentioned later) used for photosensitive resin composition to be coated with afterward, the better the filling will be.

When two or more solvents are mixed and used for the pre-wetting solvent, organic solvents used for the pre-wetting solvent contains a solvent having a boiling point of 130°C or higher, preferably 135°C or higher, at least 30 mass% preferably. Such a solvent is contained preferably 30 to 70%. The boiling point is preferably 130 to 160°C, more preferably 135 to 160°C. Containing a solvent having high boiling point prevents a surface of a semiconductor substrate from being dried during pre-wetting and dropping photosensitive resin composition, etc., and it becomes easy to spread coating.

Especially, a solvent has the most excellent solubility of photo-acid generator is preferable, such as ethyl lactate, cyclohexanone, cyclopentanone, propylene glycol monomethyl ether, propylene glycol monomethyl ether acetate, γ-butyrolactone and mixed solvent thereof.

In pre-wetting, rotational rate is preferably more than 0 and not more than 50 rpm, more preferably more than 0 and not more than 20 rpm. By this, the pre-wetting solvent 2 stays on a wafer, no bubble is generated in stepped region because pre-wetting solvent 2 covers the entire recessed portion formed by the stepped surface, and an embedding failure scarcely occurs when photosensitive resin composition is coated.

The time for keeping pre-wetting solvent 2 on the semiconductor substrate 1 depends on the size of a step, but it is preferably 1 to 30 minutes, more preferably 1 to 15 minutes.

By pre-wetting in the beginning, the photosensitive resin composition can diffuse easily in the second coating step. This leads to saving of solutions to be dropped, and loss of materials can be reduced.

### (Scraping Step)

Scraping step is a step where any excess pre-wetting solvent 2 on a semiconductor substrate 1 is scraped off, with spinning. Rotational rate is preferably 5 to 120 rpm, more preferably 80 to 100 rpm. Rotation time is 1 to 20 seconds, more preferably 3 to 15 seconds. By this, any excess pre-wetting solvent 2 can be removed without complete loss of moisture on surface of a wafer, embedding becomes easy while photosensitive resin composition is dropped, and at the same time it can suppress decrease of film thickness due to decreased viscosity, which is caused by coating solution diluted excessively with pre-wetting solvent.

### (Second Coating Step)

A second coating step is a step where a surface filled with the pre-wetting solvent 2 by spin coating, is spin-coated with photosensitive resin composition containing a resin having silicone skeleton or acrylic resin, and a photosensitive resin layer 3, which is coating film of the photosensitive resin composition, is formed. While rotating at constant rate, after scraping off pre-wetting solvent 2 in the scraping step, photosensitive resin composition is dropped. Duration of rotation after the dropping is 1 to 20 seconds, more preferably 3 to 15 seconds. Thus, due to pre-wetting solvent 2 on a wafer, dropped photosensitive resin composition can spread over on a wafer easily, even when dropped amount is small. Further, in acceleration of the rotational rate to obtain a desired thickness, it is preferable to increase the rotational rate stepwise to the maximum rotational rate so that the pre-wetting solvent 2 should not get dried.

In the second coating step, after rotating the substrate for the scraping step after pre-wetting of the first coating step, the rotation may be continued at a constant rotational rate without stop to the second coating step, and photosensitive resin composition may be dropped in the second coating step. In dropping of the photosensitive resin composition in the second coating step, the rotational rate may be accelerated after keeping rotation at the same constant rate for a certain period, to form a flat coating film. By keeping a constant rotational rate with no change in rotational rate in the steps from the scraping to the dropping of photosensitive resin composition, the photosensitive resin composition can be dropped without drying a surface of a wafer, and embedding into a semiconductor substrate having a stepped surface becomes easy.

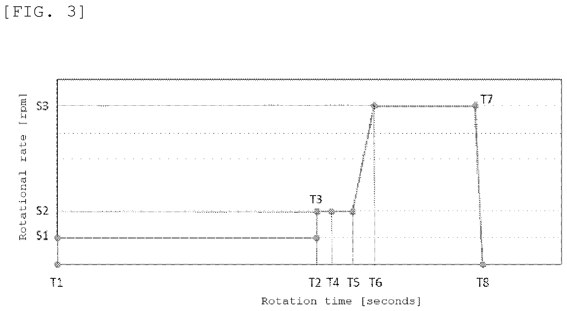

FIG. 3 shows conditions for spin-coating in the first coating step, the scraping step, and the second coating step. The horizontal axis X indicates the rotation time (seconds) in the coating processes, and the vertical axis Y indicates the rotational rate (rpm) of the semiconductor substrate in the spin-coating.

First, in the first coating step, a semiconductor substrate having a stepped surface on one side is prepared, and its rotational rate is increased from the stopped state to S1. The pre-wetting solvent is dropped when the rotational rate reaches S1, spin-coating is performed while the rotational rate S1 is maintained during the rotation time from T1 to T2. the required rotation time from T1 to T2 depends on a size of the step. The larger the step is, the longer the rotation time should be desired.

Next, as the scraping step, the rotational rate is increased from S1 to S2 during time from T2 to T3, any excess pre-wetting solvent on the semiconductor substrate is scraped off during time from T3 to T4.

Further, as the second coating step, photosensitive resin composition is dropped at T4 while the rotational rate S2 is maintained, and spin-coating is performed at the same rotational rate as one in the scraping step until T5.

Then, the rotational rate is increased slowly, from T5 to T6, to rotational rate S3 which makes film thickness the desired one. In this event, rapid increase in the rotational rate causes an embedding failure. When difference between the rotational rate S2 in scraping and the rotational rate S3 in the second coating step is over 1000 rpm, it is preferable to accelerate the rotational rate stepwise. When difference between S2 and S3 is less than 1000 rpm, it is preferable to accelerate the rotational rate over 15 to 30 seconds.

At the end, the rotational ratio is decreased from S3 to 0 rpm during time from T7 to T8, and an embedding process ends.

In case of the inventive laminate, because the photosensitive resin is in a state before curing, the photosensitive resin composition has flowability. Therefore, the pre-wetting solvent and the photosensitive resin composition (photosensitive resin layer) are mixed gradually at their boundary surface. This process generates a concentration gradient of a solvent in the stacking direction. This aspect is also to be included in the present invention. Uniform mixture of the both through further mixing at the boundary surface, enables excellent embedding in the recessed portion formed by the stepped surface.

After pre-baking a laminate after completion of embedding process, embedding of photosensitive resin all over the surface can be confirmed by observation of uniformity of a wafer surface, using an optical microscope.

### (Photosensitive Resin Composition)

The photosensitive resin layer is a coating film made from photosensitive resin composition, and the photosensitive resin composition includes resin having a silicone skeleton or acrylic resin.

When the photosensitive resin composition includes (A) a polymer having a silicone skeleton as a base polymer, the photosensitive resin composition preferably includes (B) a photo-acid generator which is decomposed by a light of 190 to 500 nm and generates an acid, and (C) a solvent.

When the photosensitive resin composition includes (A') an acrylic polymer as a base polymer, it is possible to use the photosensitive resin composition including (B') a photopolymerization initiator and (C) a solvent also.

Besides components (A), (B), and (C), or components (A'), (B'), and (C), the photosensitive resin composition can include (D) crosslinking agent, (E) quencher, and (F) antioxidant.

Hereinafter, each component will be described in detail.

### [(A) Polymer having a Silicone Skeleton]

A polymer having a silicone skeleton of the component (A) is not particularly limited, but preferably includes at least one repeating unit represented by any of the following formulae (a1) to (a4) and at least one repeating unit represented by any of the following formulae (b1) to (b4) (hereinafter, also called repeating units (a1) to (a4) and repeating units (b1) to (b4), respectively). 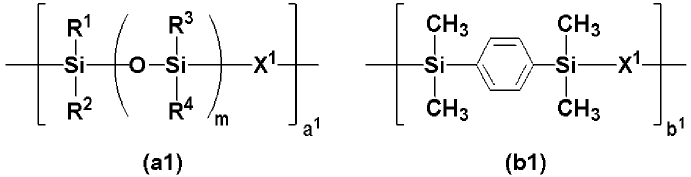 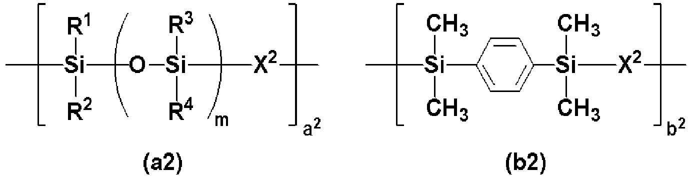 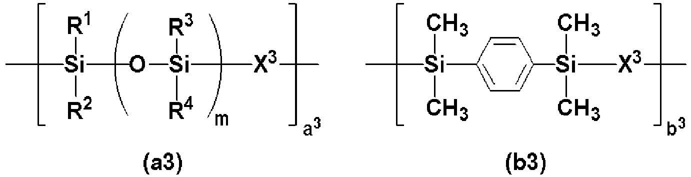 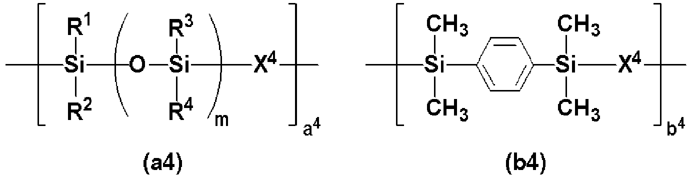 Wherein, R¹ to R⁴ each independently represent a monovalent hydrocarbon group having 1 to 8 carbon atoms; "m" represents an integer of 1 to 600; a¹ to a⁴ and b¹ to b⁴ are values satisfying, 0≤a¹<1, 0≤a²<1, 0≤a³<1, 0≤a⁴<1, 0≤b¹<1, 0≤b²<1, 0≤b³<1, 0≤b⁴<1, 0<a¹+a²+a³+a⁴<1, 0<b²+b²+b³+b⁴<1, and a¹+a²+a³+a⁴+b¹+b²+b³+b⁴=1; X¹ is a divalent group represented by the following formula (X1); X² is a divalent group represented by the following formula (X2); X³ is a divalent group represented by the following formula (X3); X⁴ is a divalent group represented by the following formula (X4), 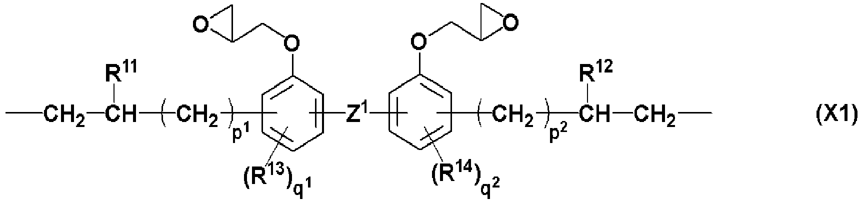 wherein, Z¹ represents a single bond, a methylene group, a propane-2,2-diyl group, a 1,1,1,3,3,3-hexafluoropropane-2,2-diyl group, or a fluorene-9,9-diyl group; R¹¹ and R¹² each independently represent a hydrogen atom or a methyl group; R¹³ and R¹⁴ each independently represent an alkyl group having 1 to 4 carbon atoms, or an alkoxy group having 1 to 4 carbon atoms; p¹ and p² each independently represent an integer of 0 to 7; q¹ and q² are each independently an integer of 0 to 2, 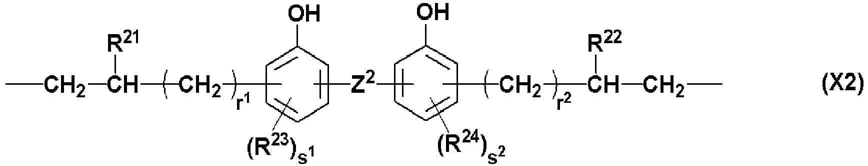 wherein, Z² represents a single bond, a methylene group, a propane-2,2-diyl group, a 1,1,1,3,3,3-hexafluoropropane-2,2-diyl group, or a fluorene-9,9-diyl group; R²¹ and R²² each independently represent a hydrogen atom or a methyl group; R²³ and R²⁴ each independently represent an alkyl group having 1 to 4 carbon atoms, or an alkoxy group having 1 to 4 carbon atoms; r¹ and r² each independently represent an integer of 0 to 7; s¹ and s² each independently represent an integer of 0 to 2, 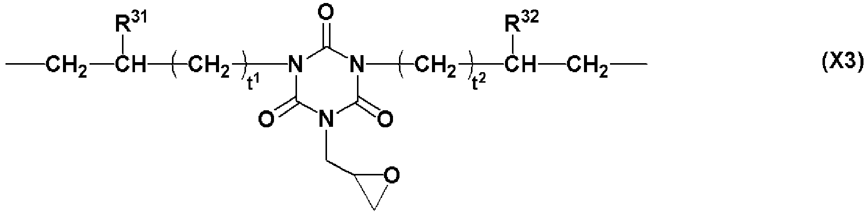 wherein, R³¹ and R³² each independently represent a hydrogen atom or a methyl group; t¹ and t² each independently represent an integer of 0 to 7, 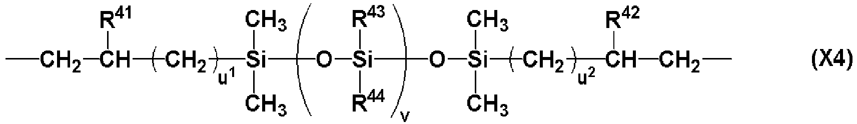 wherein, R⁴¹ and R⁴² each independently represent a hydrogen atom or a methyl group; R⁴³ and R⁴⁴ each independently represent a monovalent hydrocarbon group having 1 to 8 carbon atoms; u¹ and u² each independently represent an integer of 0 to 7; "v" represents an integer of 0 to 600.

In formulae (a1) to (a4), R¹ to R⁴ each independently represent a monovalent hydrocarbon group having 1 to 8 carbon atoms. "m" represents an integer of 1 to 600. When "m" is an integer of 2 or more, R³ each may be the same or different each other, and R⁴ each may be the same or different each other. When the repeating units (a1) to (a4) have two or more siloxane units, the siloxane units may be the same or may include two or more different siloxane units. When including two or more different siloxane units (that is, when "m" is an integer of two or more), the siloxane units may bond at random or one after the other, or may include a plurality of blocks of the same siloxane unit.

The monovalent hydrocarbon group may be linear, branched, or cyclic, and specific examples can include alkyl groups such as a methyl group, an ethyl group, a propyl group, a hexyl group, a cyclohexyl group, and a structural isomer thereof, etc., and aryl groups such as a phenyl group, etc. Among these, a methyl group and a phenyl group are preferable in light of easy sourcing of materials.

In formulae, "m" represents an integer of 1 to 600, but preferably 1 to 400, more preferably 1 to 200.

In the formula (X1), Z¹ represents a single bond, a methylene group, a propane-2,2-diyl group, a 1,1,1,3,3,3-hexafluoropropane-2,2-diyl group, or a fluorene-9,9-diyl group. R¹¹ and R¹² each independently represent a hydrogen atom or a methyl group. R¹³ and R¹⁴ each independently represent an alkyl group having 1 to 4 carbon atoms, or an alkoxy group having 1 to 4 carbon atoms, p¹ and p² each independently represent an integer of 0 to 7. q¹ and q² are each independently an integer of 0 to 2.

The alkyl group may be linear, branched, or cyclic, and specific examples can include a methyl group, an ethyl group, a propyl group, a butyl group, and a structural isomer thereof, etc. The alkoxy group may be linear, branched, or cyclic, and specific examples can include a methoxy group, an ethoxy group, a propoxy group, a butoxy group, and a structural isomer thereof, etc.

In formula (X2), Z² represents a single bond, a methylene group, a propane-2,2-diyl group, a 1,1,1,3,3,3-hexafluoropropane-2,2-diyl group, or a fluorene-9,9-diyl group. R²¹ and R²² each independently represent a hydrogen atom or a methyl group. R²³ and R²⁴ each independently represent an alkyl group having 1 to 4 carbon atoms, or an alkoxy group having 1 to 4 carbon atoms. r¹ and r² each independently represent an integer of 0 to 7. s¹ and s² each independently represent an integer of 0 to 2. Example of an alkyl group and an alkoxy group can include the same as those mentioned above.

In formula (X3), R³¹ and R³² each independently represent a hydrogen atom or a methyl group. t¹ and t² each independently represent an integer of 0 to 7.

In formula (X4), R⁴¹ and R⁴² each independently represent a hydrogen atom or a methyl group. R⁴³ and R⁴⁴ each independently represent a monovalent hydrocarbon group having 1 to 8 carbon atoms. u¹ and u² each independently represent an integer of 0 to 7. "v" represents an integer of 0 to 600, preferably 0 to 400, and more preferably 0 to 200. The monovalent hydrocarbon groups can include the same as those described for R¹ to R⁴. In groups represented by the formula (X4), when "v" is an integer of two or more, a siloxane unit represented by suffix "v" may bond at random or one after the other, and may contain a plurality of blocks of the same kind of siloxane.

The component (A), a polymer having a silicone skeleton preferably has a weight-average molecular weight (Mw) of 3,000 to 500,000, more preferably 5,000 to 200,000. In the present invention, note that Mw is a value measured in terms of polystyrene, by gel permeation chromatography (GPC) using tetrahydrofuran as a solvent.

In formulae (a1) to (a4) and (b1) to (b4), a¹ to a⁴ and b¹ to b⁴ are values satisfying, 0≤a¹<1, 0≤a²<1, 0≤a³<1, 0≤a⁴<1, 0≤b¹<1, 0≤b²<1, 0≤b³<1, 0≤b⁴<1, 0<a¹+a²+a³+a⁴<1, 0<b¹+b²+b³+b⁴<1, and a¹+a²+a³+a⁴+b¹+b²+b³+b⁴=1; preferably values satisfying 0≤a¹≤0.8, 0≤a²≤0.8, 0≤a³≤0.8, 0≤a⁴≤0.8, 0≤b¹≤0.95, 0≤b²≤0.95, 0≤b³≤0.95, 0≤b⁴≤0.95, 0.05≤a¹+a²+a³+a⁴≤0.8, 0.2≤b¹+b²+b³+b⁴≤0.95, and a¹+a²+a³+a⁴+b¹+b²+b³+b⁴=1; more preferably values satisfying 0≤a¹≤0.7, 0≤a²≤0.7, 0≤a³≤0.7, 0≤a⁴≤0.7, 0≤b¹≤0.9, 0≤b²≤0.9, 0≤b³≤0.9, 0≤b⁴≤0.9, 0.1≤a¹+a²+a³+a⁴≤0.7, 0.3≤b¹+b²+b³+b⁴≤0.9, and a¹+a²+a³+a⁴+b¹+b²+b³+b⁴=1.

A polymer having a silicone skeleton in component (A) preferably have a crosslinking group such as an epoxy group, a hydroxy group, etc., or a reactive site generating crosslinking reaction. That is, the polymer preferably includes at least one selected from repeating units (a1) to (a3) and at least one selected from repeating units (b1) to (b3). Here, in formulae (a1) to (a4) and (b1) to (b4), a¹ to a⁴ and b¹ to b⁴ are preferably values satisfying, 0≤a¹<1, 0≤a²<1, 0≤a³<1, 0≤a⁴<1, 0≤b¹<1, 0≤b²<1, 0≤b³<1, 0≤b⁴<1, 0<a¹+a²+a³<1, 0<b²+b²+b³<1, and a¹+a²+a³+a⁴+b¹+b²+b³+b⁴=1; more preferably values satisfying 0≤a¹≤0.8, 0≤a²≤0.8, 0≤a³≤0.8, 0≤a⁴≤0.8, 0≤b¹≤0.95, 0≤b²≤0.95, 0≤b³≤0.95, 0≤b⁴≤0.95, 0.05≤a¹+a²+a³≤0.8, 0.2≤b¹+b²+b³≤0.95, and a¹+a²+a³+a⁴+b¹+b²+b³+b⁴=1; further preferably values satisfying 0≤a¹≤0.7, 0≤a²≤0.7, 0≤a³≤0.7, 0≤a⁴≤0.7, 0≤b¹≤0.9, 0≤b²≤0.9, 0≤b³≤0.9, 0≤b⁴≤0.9, 0.1≤a¹+a²+a³≤0.7, 0.3≤b¹+b²+b³≤0.9, and a¹+a²+a³+a⁴+b¹+b²+b³+b⁴=1.

Especially, a polymer having a silicone skeleton in component (A) preferably have repeating units a3 and b3. Here, in formulae (a1) to (a4) and (b1) to (b4), a¹ to a⁴ and b¹ to b⁴ are preferably values satisfying, 0≤a¹<1, 0≤a²<1, 0<a³<1, 0≤a⁴<1, 0≤b¹<1, 0≤b²<1, 0<b³<1, 0≤b⁴<1, 0<a¹+a²+a³+a⁴<1, 0<b¹+b²+b³+b⁴<1, and a¹+a²+a³+a⁴+b¹+b²+b³+b⁴=1; more preferably values satisfying 0≤a¹<0.8, 0≤a²<0.8, 0<a³≤0.8, 0≤a⁴<0.8, 0≤b¹<0.95, 0≤b²<0.95, 0<b³≤0.95, 0≤b⁴<0.95, 0.05≤a¹+a²+a³+a⁴≤0.8, 0.2≤b¹+b²+b³+b⁴≤0.95, and a¹+a²+a³+a⁴+b¹+b²+b³+b⁴=1; further preferably values satisfying 0≤a¹<0.7, 0≤a²<0.7, 0<a³≤0.7, 0≤a⁴<0.7, 0≤b¹<0.9, 0≤b²<0.9, 0<b³≤0.9, 0≤b⁴<0.9, 0.1≤a¹+a²+a³+a⁴≤0.7, 0.3≤b¹+b²+b³+b⁴≤0.9, and a¹+a²+a³+a⁴+b¹+b²+b³+b⁴=1.

The aforementioned repeating units may bond at random or may bond as block polymers. Siloxane units in each repeating unit may bond at random or may contain a plurality of blocks of the same kind of siloxane. The silicone (siloxane unit) has preferably a content ratio of 30 to 80 mass%, in the polymer having a silicone skeleton.

The photosensitive resin layer using the polymer having a silicone skeleton of component (A) has good adhesiveness to laminates, semiconductor substrates, etc., good patternability, good crack resistance, and good heat resistance.

The polymer having a silicone skeleton of component (A) may be used solely or in combination of two kinds or more.

### [Manufacturing Method of (A) Polymer having a Silicone Skeleton]

The polymer having a silicone skeleton can be manufactured by addition polymerization, in the presence of a metal catalyst, of a compound represented by the following formula (1) (hereinafter, also called compound (1)), a compound represented by the following formula (2) (hereinafter, also called compound (2)), and a compound selected from the group consisting of a compound represented by the following formula (3) (hereinafter, also called compound (3)), a compound represented by the following formula (4) (hereinafter, also called compound (4)), a compound represented by the following formula (5) (hereinafter, also called compound (5)), and a compound represented by the following formula (6) (hereinafter, also called compound (6)). 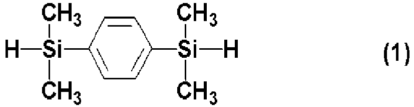 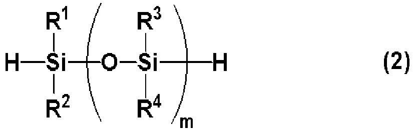 Wherein, R¹ to R⁴, and "m" is the same as described above. 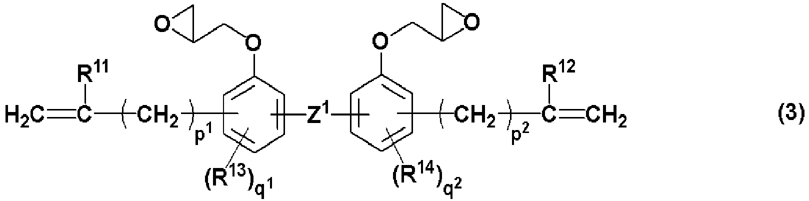 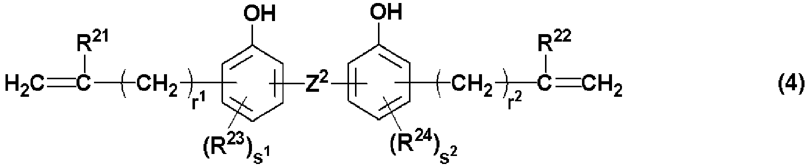 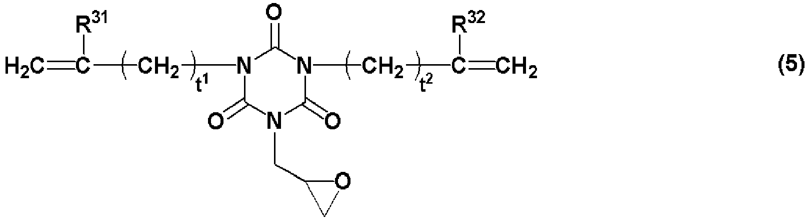 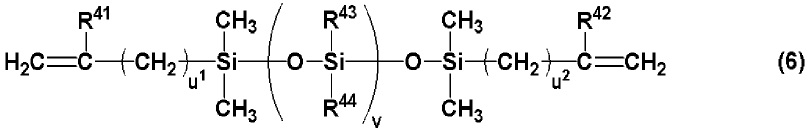 Wherein, R¹¹ to R¹⁴, R²¹ to R²⁴, R³¹, R³², R⁴¹ to R⁴⁴, Z¹, Z², p¹, p², q¹, q², r¹, r², s¹, s², t¹, t², u¹, u², and "v" is the same as described above.

As the metal catalyst, it is possible to use: single platinum group metals such as platinum (including platinum black), rhodium, palladium, etc.; platinum chloride, chloroplatinic acid and chloroplatinates such as H₂PtCl₄·xH₂O, H₂PtCl₆·xH₂O, NaHPtCl₆·xH₂O, KHPtCl₆·xH₂O, Na₂PtCl₆·xH₂O, K₂PtCl₄·xH₂O, PtCl₄·xH₂O, PtCl₂, Na₂HPtCl₄·xH₂O (here, "x" is preferably an integer of 0 to 6, especially 0 or 6 is preferable.); alcohol-modified chloroplatinic acid (for example, those described in Specification of U.S. Patent No. 3,220,972); complex of chloroplatinic acid and olefin (for example, those described in Specifications of U.S. Patent No. 3,159,601, 3,159,662, and 3,775,452); platinum group metals such as platinum black and palladium supported on a carrier such as alumina, silica, carbon, etc.; rhodium-olefin complex; chlorotris(triphenylphosphine)rhodium (so-called Wilkinson catalyst); and complexes of platinum chloride, chloroplatinic acid, or chloroplatinate with vinyl group-containing siloxanes (especially, vinyl group-containing cyclic siloxanes), etc.

The amount of catalyst used is the amount of catalyst, generally, preferably used in an amount of 0.001 to 0.1 parts by mass, more preferably 0.01 to 0.1 parts by mass based on 100 parts by mass of sum of compounds (1) to (6) .

In the addition polymerization, a solvent may be used as necessary. The solvent is, for example, preferably hydrocarbon solvents such as toluene and xylene.

The addition polymerization is preferably performed preferably at a temperature of 40 to 150°C in light of preventing catalyst deactivation and enabling short time completion of the polymerization, more preferably 60 to 120°C. The duration for the addition polymerization depends on a type and an amount of resin to be obtained, but is preferably about 0.5 to 100 hours, more preferably 0.5 to 30 hours, in order to avoid intervention of moisture in the addition polymerization system. When a solvent is used, by the distillation of the solvent, a polymer having a silicone skeleton of component (A) can be obtained.

A method of the reaction is not particularly limited. For example, first at least one compound selected from compounds (3) to (6) is heated, and then metal catalyst is added to the compound, followed by dropping of compounds (1) and (2) for 0.1 to 5 hours.

It is best to blend each of raw material compounds so that a ratio of sum of hydrosilyl groups contained in compounds represented by formula (1) and formula (2) should be preferably 0.67 to 1.67 in terms of molar ratio, more preferably 0.83 to 1.25, to sum of alkenyl groups contained in at least one compound selected from compounds (3) to (6).

Mw of the polymer having a silicone skeleton can be controlled by using a monoallyl compounds such as o-allylphenol, monohydrosilanes such as triethylhydrosilane, or monohydrosiloxanes, as a molecular weight regulator.

### [(A') Acrylic Polymer]

Component (A) an acrylic Polymer is not particularly limited as long as it is a polymer of (meth)acrylate ester. Weight-average molecular weight Mw is not particularly limited either, but it is preferable to use a polymer having Mw of 10,000 to 200,000, more preferably a polymer having Mw of 20,000 to 150,000. Preferable acrylic polymers are, for example, ART CURE MAP-4050, ART CURE MAP-2801, ART CURE RA-3953 (made by Negami Chemical Industrial Co., Ltd.), PHORET ZAH-106, and PHORET ZAH-110 (Made by Soken Chemical & Engineering Co., Ltd.).

### [(B) Photo-acid Generator]

Component (B) a photoacid generator, which is combined with a polymer having a silicone skeleton of component (A), is not particularly limited as long as it is decomposed by light irradiation and generate acid, but the photo-acid generator is preferably to generate acid by irradiating light having a wavelength of 190 to 500 nm. Because the composition used in the present invention is excellent in compatibility with an acid generator, a wide variety of acid generators can be used.

(B) the photo-acid generator is used as a curing catalyst. Examples of the photo-acid generator can include an onium salt, a diazomethane derivative, a glyoxime derivative, a β-ketosulfone derivative, a disulfone derivative, a nitrobenzylsulfonate derivative, a sulfonic ester derivative, an imido-yl-sulfonate derivative, an oxime sulfonate derivative, an iminosulfonate derivative, a triazine derivative, etc.

Examples of the onium salt can include a sulfonium salt represented by the following formula (B1) and an iodonium salt represented by the following formula (B2).

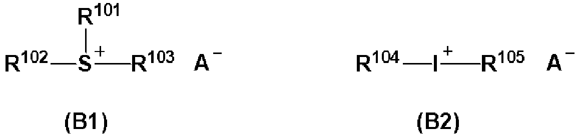

In the above formulae (B1) and (B2), R¹⁰¹ to R¹⁰⁵ each independently represent: an alkyl group having 1 to 12 carbon atoms, which may have a substituent; an aryl group having 6 to 12 carbon atoms, which may have a substituent; or an aralkyl group having 7 to 12 carbon atoms, which may have a substituent. A⁻ is a non-nucleophilic counter ion.

The alkyl group may be linear, branched, or cyclic. Specific examples of the alkyl group can include a methyl group, an ethyl group, a n-propyl group, an isopropyl group, a cyclopropyl group, a n-butyl group, an isobutyl group, a sec-butyl group, a tert-butyl group, a cyclobutyl group, an n-pentyl group, a cyclopentyl group, a cyclohexyl group, a norbornyl group, an adamantyl group, etc. Examples of the aryl group can include a phenyl group, a naphthyl group, a biphenylyl group, etc. Examples of the aralkyl group can include a benzyl group and a phenethyl group, etc.

The examples of the substituent can include an oxo group, a linear, branched, or cyclic alkoxy group having 1 to 12 carbon atoms, a linear, branched, or cyclic alkyl group having 1 to 12 carbon atoms, an aryl group having 6 to 24 carbon atoms, an aralkyl group having 7 to 25 carbon atoms, an aryloxy group having 6 to 24 carbon atoms, an arylthio group having 6 to 24 carbon atoms, etc.

R¹⁰¹ to R¹⁰⁵ is preferably; alkyl groups, which may have a substituent, such as a methyl group, an ethyl group, a propyl group, a butyl group, a cyclohexyl group, a norbornyl group, an adamantyl group, and a 2-oxocyclohexyl group, etc.; an aryl group, which may have a substituent, such as a phenyl group, a naphthyl group, a biphenylyl group, an o-, m- or p-methoxyphenyl group, an ethoxyphenyl group, m- or p-tert-butoxyphenyl group, a 2-, 3- or 4-methylphenyl group, an ethylphenyl group, a 4-tert-butylphenyl group, 4-butylphenyl group, a dimethylphenyl group, a terphenylyl group, a biphenylyloxyphenyl group, and a biphenylylthiophenyl group, etc.; an aralkyl group, which may have a substituent, such as a benzyl group and a phenethyl group, etc. Among these, an aryl group which may have a substituent and an aralkyl group which may have a substituent are more preferable.

The non-nucleophilic counter ion includes a halide ion such as a chloride ion and a bromide ion; a fluoroalkanesulfonate ion such as a triflate ion, a 1,1,1-trifluoroethanesulfonate ion, and a nonafluorobutanesulfonate ion, etc.; an aryl sulfonate ion such as a tosylate ion, a benzenesulfonate ion, a 4-fluorobenzenesulfonate ion, and a 1,2,3,4,5-pentafluorobenzenesulfonate ion, etc.; an alkanesulfonate ion such as a mesylate ion, and a butanesulfonate ion, etc.; a fluoroalkanesulfonimide ion such as a trifluoromethanesulfonimide ion; a fluoroalkanesulfonylmethide ion such as a tris(trifluoromethanesulfonyl)methide ion, etc.; a borate ion such as a tetrakis phenylborate ion, and a tetrakis(pentafluorophenyl)borate ion; etc.

The diazomethane derivative includes a compound represented by the following formula (B3).

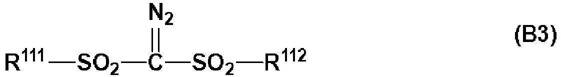

In the formula (B3), R¹¹¹ and R¹¹² are each independently an alkyl or halogenated alkyl group having 1 to 12 carbon atoms, an aryl group, which may have a substituent, having 6 to 12 carbon atoms, or an aralkyl group having 7 to 12 carbon atoms.

The alkyl group may be linear, branched, or cyclic, and specific examples can include the same as exemplified in description for R¹⁰¹ to R¹⁰⁵. The halogenated alkyl group include a trifluoromethyl group, a 1,1,1-trifluoroethyl group, a 1,1,1-trichloroethyl group, a nonafluorobutyl group, etc.

The aryl group which may have a substituent can include: a phenyl group; alkoxyphenyl groups such as a 2-, 3- or 4-methoxyphenyl group, a 2-, 3- or 4-ethoxyphenyl group, a 3- or 4-tert-butoxyphenyl group, etc.; alkylphenyl groups such as a 2-, 3- or 4-methylphenyl group, an ethylphenyl group, a 4-tert-butylphenyl group, a 4-butylphenyl group, a dimethylphenyl group, etc.; halogenated aryl groups such as a fluorophenyl group, a chlorophenyl group, a 1,2,3,4,5-pentafluorophenyl group, etc. Examples of the aralkyl group can include a benzyl group, a phenethyl group, etc.

The glyoxime derivatives can includes compounds represented by the following formula (B4).

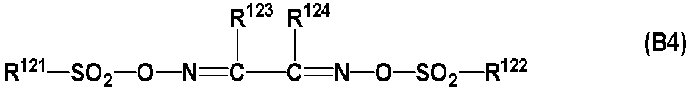

In the formula (B4), R¹²¹ to R¹²⁴ is each independently an alkyl group having 1 to 12 carbon atoms or being halogenated, an aryl group, which may have a substituent, having 6 to 12 carbon atoms, or an aralkyl group having 7 to 12 carbon atoms. Further, R¹²³ and R¹²⁴ may bond each other to form a ring together with the bonded carbon atoms. When forming a ring, a group formed by bonding of R¹²³ and R¹²⁴ is a linear or branched alkylene group having 1 to 12 carbon atoms.

Specific examples of the alkyl group, the halogenated alkyl group, the aryl group which may have a substituent, and the aralkyl group can include the same as exemplified for R¹¹¹ and R¹¹². The linear or branched alkylene groups include a methylene group, an ethylene group, a propylene group, a butylene group, a hexylene group, etc.

Specific examples of the onium salt can include diphenyliodonium trifluoromethanesulfonate, (p-tert-butoxyphenyl)phenyliodonium trifluoromethanesulfonate, diphenyliodonium p-toluenesulfonate, (p-tert-butoxyphenyl)phenyliodonium p-toluenesulfonate, triphenylsulfonium trifluoromethanesulfonate, (p-tert-butoxyphenyl)diphenylsulfonium trifluoromethanesulfonate, bis(p-tert-butoxyphenyl)phenylsulfonium trifluoromethanesulfonate, tris(p-tert-butoxyphenyl)sulfonium trifluoromethanesulfonate, triphenylsulfonium p-toluenesulfonate, (p-tert-butoxyphenyl)diphenylsulfonium p-toluenesulfonate, bis(p-tert-butoxyphenyl)phenylsulfonium p-toluenesulfonate, tris(p-tert-butoxyphenyl)sulfonium p-toluenesulfonate, triphenylsulfonium nonafluorobutanesulfonate, triphenylsulfonium butanesulfonate, trimethylsulfonium trifluoromethanesulfonate, trimethylsulfonium p-toluenesulfonate, cyclohexylmethyl(2-oxocyclohexyl)sulfonium trifluoromethanesulfonate, cyclohexylmethyl(2-oxocyclohexyl)sulfonium p-toluenesulfonate, dimethylphenylsulfonium trifluoromethanesulfonate, dimethylphenylsulfonium p-toluenesulfonate, dicyclohexylphenylsulfonium trifluoromethanesulfonate, dicyclohexylphenylsulfonium p-toluenesulfonate, bis(4-tert-butylphenyl)iodonium hexafluorophosphate, diphenyl(4-thiophenoxyphenyl)sulfonium hexafluoroantimonate, [4-(4-biphenylylthio)phenyl]-4-biphenylylphenylsulfonium tris(trifluoromethanesulfonyl)methide, triphenylsulfonium tetrakis(fluorophenyl)borate, tris[4-(4-acetylphenyl)thiophenyl]sulfonium tetrakis(fluorophenyl)borate, triphenylsulfonium tetrakis(pentafluorophenyl)borate, tris[4-(4-acetylphenyl)thiophenyl]sulfonium tetrakis(pentafluorophenyl)borate, etc.

Specific examples of the diazomethane derivative can include bis(benzenesulfonyl)diazomethane, bis(p-toluenesulfonyl)diazomethane, bis(xylenesulfonyl)diazomethane, bis(cyclohexylsulfonyl)diazomethane, bis(cyclopentylsulfonyl)diazomethane, bis(n-butylsulfonyl)diazomethane, bis(isobutylsulfonyl)diazomethane, bis(sec-butylsulfonyl)diazomethane, bis(n-propylsulfonyl)diazomethane, bis(isopropylsulfonyl)diazomethane, bis(tert-butylsulfonyl)diazomethane, bis(n-pentylsulfonyl)diazomethane, bis(isopentylsulfonyl)diazomethane, bis(sec-pentylsulfonyl)diazomethane, bis(tert-pentylsulfonyl)diazomethane, 1-cyclohexylsulfonyl-1-(tert-butylsulfonyl)diazomethane, 1-cyclohexylsulfonyl-1-(tert-pentylsulfonyl)diazomethane, 1-tert-pentylsulfonyl-1-(tert-butylsulfonyl)diazomethane, etc.

Specific examples of the glyoxime derivative can include bis-o-(p-toluenesulfonyl)-α-dimethylglyoxime, bis-o-(p-toluenesulfonyl)-α-diphenylglyoxime, bis-o-(p-toluenesulfonyl)-α-dicyclohexylglyoxime, bis-o-(p-toluenesulfonyl)-2,3-pentanedioneglyoxime, bis-(p-toluenesulfonyl)-2-methyl-3,4-pentanedioneglyoxime, bis-o-(n-butanesulfonyl)-α-dimethylglyoxime, bis-o-(n-butanesulfonyl)-α-diphenylglyoxime, bis-o-(n-butanesulfonyl)-α-dicyclohexylglyoxime, bis-o-(n-butanesulfonyl)-2,3-pentanedioneglyoxime, bis-o-(n-butanesulfonyl)-2-methyl-3,4-pentanedioneglyoxime, bis-o-(methanesulfonyl)-α-dimethylglyoxime, bis-o-(trifluoromethanesulfonyl)-α-dimethylglyoxime, bis-o-(1,1,1-trifluoroethanesulfonyl)-α-dimethylglyoxime, bis-o-(tert-butanesulfonyl)-α-dimethylglyoxime, bis-o-(perfluorooctanesulfonyl)-α-dimethylglyoxime, bis-o-(cyclohexanesulfonyl)-α-dimethylglyoxime, bis-o-(benzenesulfonyl)-α-dimethylglyoxime, bis-o-(p-fluorobenzenesulfonyl)-α-dimethylglyoxime, bis-o-(p-tert-butylbenzenesulfonyl)-α-dimethylglyoxime, bis-o-(xylenesulfonyl)-α-dimethylglyoxime, bis-o-(camphorsulfonyl)-α-dimethylglyoxime, etc.

Specific examples of the β-ketosulfone derivative can include 2-cyclohexylcarbonyl-2-(p-toluenesulfonyl)propane, 2-isopropylcarbonyl-2-(p-toluenesulfonyl)propane, etc.

Specific examples of the disulfone derivative can include diphenyldisulfone and dicyclohexyldisulfone, etc.

Specific examples of the nitrobenzylsulfonate derivative can include 2,6-dinitrobenzyl p-toluenesulfonate and 2,4-dinitrobenzyl p-toluenesulfonate, etc.

Specific examples of the sulfonic ester derivative can include 1,2,3-tris(methanesulfonyloxy)benzene, 1,2,3-tris(trifluoromethanesulfonyloxy)benzene, 1,2,3-tris(p-toluenesulfonyloxy)benzene, etc.

Specific example of the imido-yl-sulfonate derivatives can include phthalimido-yl-triflate, phthalimido-yl-tosylate, 5-norbornene-2,3-dicarboximido-yl-triflate, 5-norbornene-2,3-dicarboximido-yl-tosylate, 5-norbornene-2,3-dicarboximido-yl-n-butylsulfonate, n-trifluoromethylsulfonyloxynaphthylimide, etc.

Specific examples of the oxime sulfonate derivative can include α-(benzenesulfoniumoxyimino)-4-methylphenylacetonitrile, etc.

Specific examples of the iminosulfonate derivative can include (5-(4-methylphenyl)sulfonyloxyimino-5H-thiophen-2-ylidene)-(2-methylphenyl)acetonitrile, (5-(4-(4-methylphenylsulfonyloxy)phenylsulfonyloxyimino)-5H-thiophen-2-ylidene)-(2-methylphenyl)-acetonitrile, etc.

Specific example of the triazine derivatives, can include 2-(methoxyphenyl)-4,6-bis(trichloromethyl)-s-triazine, 2-[2-(3,4-dimethoxyphenyl)ethenyl]-4,6-bis(trichloromethyl)-s-triazine, 2-[2-(furan-2-yl)ethenyl]-4,6-bis(trichloromethyl)-s-triazine, 2-[2-(5-methylfuran-2-yl)ethenyl]-4,6-bis(trichloromethyl)-s-triazine, etc.

Further, 2-methyl-2-[(4-methylphenyl)sulfonyl]-1-[(4-methylthio)phenyl]-1-propane, etc. can also be suitably used.

As component (B) the photo-acid generator, the onium salt is specifically preferable, and the sulfonium salt is more preferable.

In terms of photo-curability, component (B) is contained preferably 0.05 to 20 parts by mass, more preferably 0.05 to 5 parts by mass, based on 100 parts by mass of component (A). When component (B) is contained 0.05 or more parts by mass, it is preferable because there is no risk of insufficient generation to allow the crosslinking reaction to proceed sufficiently. When component (B) is contained 20 or less parts by mass, it is preferable because increased absorbance of the photo-acid generator itself can be suppressed and there is no risk of a problem of reducing transparency. Component (B) may be used solely, or in combination of two or more kind.

### [(B') Photopolymerization Initiator]

Component (B') a photopolymerization initiator to be combined with component (A') an acrylic polymer may be publicly known, and not particularly limited. The photopolymerization initiators are preferably, for example, Irgacure OXE01 (made by BASF Japan Ltd.), and Irgacure OXE02 Irgacure OXE01(made by BASF Japan Ltd.).

### [(C) Solvent]

The photosensitive resin composition used in the present invention may further contain (C) a solvent. The solvent is not particularly limited, as long as components (A), (A'), (B), (B'), and the additives described later can be solved in the solvent. An organic solvent is preferable because an organic solvent has excellent solubility for these components.

Examples of the organic solvent can include: ketones such as cyclohexanone, cyclopentanone, and methyl-2-n-pentyl ketone, etc.; alcohols such as 3-methoxybutanol, 3-methyl-3-methoxybutanol, 1-methoxy-2-propanol, and 1-ethoxy-2-propanol, etc.; ethers such as propylene glycol monomethyl ether (PGME), ethylene glycol monomethyl ether, propylene glycol monoethyl ether, ethylene glycol monoethyl ether, propylene glycol dimethyl ether, and diethylene glycol dimethyl ether, etc.; esters such as propylene glycol monomethyl ether acetate (PGMEA), propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, propylene glycol mono-tert-butyl ether acetate, and γ-butyrolactone, etc. These organic solvents can be used solely, or in combination of two or more kinds. Particularly preferred are ethyl lactate, cyclohexanone, cyclopentanone, PGMEA, γ-butyrolactone or a mixed solvent thereof, because these has the best solubility for the photo-acid generator.

In terms of compatibility of the photosensitive resin composition and viscosity, the component (C) is preferably used in an amount of 50 to 2,000 parts by mass, more preferably 50 to 1,000 parts by mass, particularly preferably 50 to 100 parts by mass, based on 100 parts by mass of sum of the components (A) and (B) .

### [(D) Crosslinking Agent]

The photosensitive resin composition used in the present invention contain preferably (D) a crosslinking agent further. The crosslinking agent causes a polycondensation reaction with a phenolic hydroxy group of the component (A) or an alkoxy group represented by R¹³, R¹⁴, R²³ or R²⁴, is a component to make patterning easy, and increases the strength of a cured product further.

The crosslinking agent is preferably resin having Mw of 150 to 10,000, especially Mw of 200 to 3,000. When Mw is 150 or more, sufficient photo-curability can be obtained. When Mw is 10,000 or less, it is preferable because there is no risk of deteriorating heat-resistance of cured composition.

The crosslinking agent is: a nitrogen-containing compound having on average two or more methylol groups and/or alkoxymethyl groups in one molecule, such as a melamine compound, a guanamine compound, a glycoluril compound, an urea compound, etc.; a formaldehyde or formaldehyde-alcohol modified amino condensate; a phenolic compound having on average two or more methylol groups or alkoxymethyl groups in one molecule; and an epoxy compound having on average two or more epoxy groups in one molecule.

The melamine compound can include a compound represented by the following formula (D1).

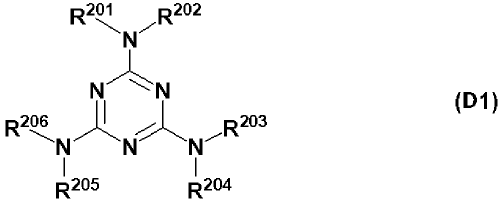

In the formula (D1), R²⁰¹ to R²⁰⁶ each independently represent a methylol group, an alkoxymethyl group having 2 to 5 carbon atoms, or a hydrogen atom, but at least one of them is a methylol group or an alkoxymethyl group. The alkoxymethyl group can include a methoxymethyl group, an ethoxymethyl group, etc.

A melamine compound represented by formula (D1) can include trimethoxymethylmonomethylolmelamine, dimethoxymethylmonomethylolmelamine, trimethylolmelamine, hexamethylolmelamine, hexamethoxymethylmelamine, hexaethoxymethylmelamine, etc.

The melamine compound represented by formula (D1) can be obtained, for example, by first methylolating a melamine monomer with formaldehyde according to a publicly known method, or by further alkoxylating this compound with alcohol. The alcohol is preferably lower alcohol, for example, alcohol having 1 to 4 carbon atoms.

The guanamine compound can include tetramethylolguanamine, tetramethoxymethylguanamine, tetramethoxyethylguanamine, etc.

The glycoluril compound can include tetramethylol glycoluril, tetrakis(methoxymethyl)glycoluril, etc.

The urea compound can include tetramethylolurea, tetramethoxymethylurea, tetramethoxyethylurea, tetraethoxymethylurea, tetrapropoxymethylurea, etc.

The formaldehyde or formaldehyde-alcohol modified amino condensate can include formaldehyde or formaldehyde-alcohol modified melamine condensates, formaldehyde or formaldehyde-alcohol modified urea condensates, etc.

The modified melamine condensates can include a compound obtained by addition condensation polymerization with represented by formula (D1), or a multimer thereof (for example oligomers such as dimers, trimers, etc.), and formaldehyde according to conventional methods until a desired molecular weight is reached.

The formaldehyde or formaldehyde-alcohol modified urea condensates can include methoxymethylated urea condensate, ethoxymethylated urea condensate, propoxymethylated urea condensate, etc.

The modified urea condensates can be obtained, for example, by methylolating a urea condensate having a desired molecular weight with formaldehyde according to a publicly known method, or by further alkoxylating this compound with alcohol.

The phenolic compound having on average two or more methylol groups or alkoxymethyl groups in one molecule can include (2-hydroxy-5-methyl)-1,3-benzenedimethanol, 2,2',6,6'-tetramethoxymethylbisphenol A, etc.

The epoxy compound having on average two or more epoxy groups in one molecule can include: bisphenol type epoxy resins such as bisphenol A type epoxy resin, bisphenol F type epoxy resin, etc.; novolac type epoxy resin such as phenol novolac type epoxy resin, cresol novolac type epoxy resin, etc.; triphenolalkane type epoxy resin; biphenyl type epoxy resin; dicyclopentadiene-modified phenol novolac type epoxy resins; phenol aralkyl type epoxy resins; biphenylaralkyl type epoxy resins; naphthalene ring-containing epoxy resins; glycidyl ester type epoxy resins; alicyclic epoxy resins; heterocyclic epoxy resins; etc.

When containing component (D), its content amount is preferably 0.5 to 50 parts by mass, more preferably 1 to 30 parts by mass, based on 100 parts by mass of component (A). When 0.5 parts by mass or more, sufficient curability can be obtained by light irradiating. When 50 parts by mass or less, the cured composition can exhibit advantageous effects of the present invention fully because the content ratio of component (A) in the photosensitive resin composition does not decrease. Component (D) a crosslinking agent can be used solely or in combination of two kinds or more.

### [(E) Quencher]

The photosensitive resin composition used in the present invention may further include (E) a quencher. A suitable quencher is a compound that can suppress diffusion velocity of an acid generated by a photo-acid generator in photosensitive resin film, which is cured material of photosensitive resin layer. By blending of such a quencher, it is possible to enhance resolution, suppress a sensitivity change after exposure, decrease substrates dependence or environmental dependence, and improve exposure latitude and patterning shape.

Examples of the quencher include ammonia, primary, secondary, or tertiary aliphatic amines, mixed amines, aromatic amines, heterocyclic amines, nitrogen-containing compounds having carboxy groups, nitrogen-containing compounds having sulfonyl groups, nitrogen-containing compounds having hydroxy groups, nitrogen-containing compounds having hydroxyphenyl groups, alcoholic nitrogen-containing compounds, amide derivatives, imide derivatives, etc.

The primary aliphatic amines can include methylamine, ethylamine, n-propylamine, isopropylamine, n-butylamine, isobutylamine, sec-butylamine, tert-butylamine, pentylamine, tert-pentylamine, cyclopentylamine, hexylamine, cyclohexylamine, heptylamine, octylamine, nonylamine, decylamine, dodecylamine, cetylamine, methylenediamine, ethylenediamine, tetraethylenepentamine, etc.

The secondary aliphatic amines can include dimethylamine, diethylamine, di-n-propylamine, diisopropylamine, di-n-butylamine, diisobutylamine, di-sec-butylamine, dipentylamine, dicyclopentylamine, dihexylamine, dicyclohexylamine, diheptylamine, dioctylamine, dinonylamine, didecylamine, didodecylamine, dicetylamine, N,N-dimethylmethylenediamine, N,N-dimethylethylenediamine, N,N-dimethyltetraethylenepentamine, etc.

The tertiary aliphatic amines can include trimethylamine, triethylamine, tri-n-propylamine, triisopropylamine, tri-n-butylamine, triisobutylamine, tri-sec-butylamine, tripentylamine, tricyclopentylamine, trihexylamine, tricyclohexylamine, triheptylamine, trioctylamine, trinonylamine, tridecylamine, tridodecylamine, tricetylamine, N,N,N',N'-tetramethylmethylenediamine, N,N,N',N'-tetramethylethylenediamine, N,N,N',N'-tetramethyltetraethylenepentamine,etc.

The mixed amines can include dimethylethylamine, methylethylpropylamine, benzylamine, phenethylamine, benzyldimethylamine, etc.

The aromatic amines and the heterocyclic amines can include aniline derivatives (for example, aniline, N-methylaniline, N-ethylaniline, N-propylaniline, N,N-dimethylaniline, 2-methylaniline, 3-methylaniline, 4-methylaniline, ethylaniline, propylaniline, trimethylaniline, 2-nitroaniline, 3-nitroaniline, 4-nitroaniline, 2,4-dinitroaniline, 2,6-dinitroaniline, 3,5-dinitroaniline, N,N-dimethyltoluidine, etc.), diphenyl(p-tolyl)amine, methyldiphenylamine, triphenylamine, phenylenediamine, naphthylamine, diaminonaphthalene, pyrrole derivatives (for example, pyrrole, 2H-pyrrole, 1-methylpyrrole, 2,4-dimethylpyrrole, 2, 5-dimethylpyrrole, N-methylpyrrole, etc.), oxazole derivatives (for example, oxazole, isoxazole, etc.), thiazole derivatives (for example, thiazole, isothiazole, etc.), imidazole derivatives (for example, imidazole, 4-methylimidazole, 4-methyl-2-phenylimidazole, etc.), pyrazole derivatives, furazane derivatives, pyrroline derivatives (for example, pyrroline, 2-methyl-1-pyrroline, etc.), pyrrolidine derivatives (for example, pyrrolidine, N-methylpyrrolidine, pyrrolidinone, N-methyl-2-pyrrolidone, etc.), imidazoline derivatives, imidazolidine derivatives, pyridine derivatives (for example, pyridine, methylpyridine, ethylpyridine, propylpyridine, butylpyridine, 4-(1-butylpentyl)pyridine, dimethylpyridine, trimethylpyridine, triethylpyridine, phenylpyridine, 3-methyl-2-phenylpyridine, 4-tert-butylpyridine, diphenylpyridine, benzylpyridine, methoxypyridine, butoxypyridine, dimethoxypyridine, 1-methyl-2-pyridine, 4-pyrrolidinopyridine, 1-methyl-4-phenylpyridine, 2-(1-ethylpropyl)pyridine, aminopyridine, dimethylaminopyridine, etc.), pyridazine derivatives, pyrimidine derivatives, pyrazine derivatives, pyrazoline derivatives, pyrazolidine derivatives, piperidine derivatives, piperazine derivatives, morpholine derivatives, indole derivatives, isoindole derivatives, 1H-indazole derivatives, indoline derivatives, quinoline derivatives (for example, quinoline, 3-quinoline carbonitrile, etc.), isoquinoline derivatives, cinnoline derivatives, quinazoline derivatives, quinoxaline derivatives, phthalazine derivatives, purine derivatives, pteridine derivatives, carbazole derivatives, phenanthridine derivatives, acridine derivatives, phenazine derivatives, 1,10-phenanthroline derivatives, adenine derivatives, adenosine derivatives, guanine derivatives, guanosine derivatives, uracil derivatives, uridine derivatives, etc.

The nitrogen-containing compounds having carboxy groups can include aminobenzoic acid, indolecarboxylic acid, amino acid derivatives (for example, nicotinic acid, alanine, arginine, aspartic acid, glutamic acid, glycine, histidine, isoleucine, glycylleucine, leucine, methionine, phenylalanine, threonine, lysine, 3-aminopyrazine-2-carboxylic acid, methoxyalanine, etc.).

The nitrogen-containing compounds having a sulfonyl group can include 3-pyridine sulfonic acid, pyridinium p-toluenesulfonate, etc.

The nitrogen-containing compounds having hydroxy groups, the nitrogen-containing compound having hydroxyphenyl groups, an alcoholic nitrogen-containing compound can include 2-hydroxypyridine, aminocresol, 2-quinolinediol, 3-indolemethanol hydrate, monoethanolamine, diethanolamine, triethanolamine, N-ethyldiethanolamine, N,N-diethylethanolamine, triisopropanolamine, 2,2'-iminodiethanol, 2-aminoethanol, 3-amino-1-propanol, 4-amino-1-butanol, 4-(2-hydroxyethyl)morpholine, 2-(2-hydroxyethyl)pyridine, 1-(2-hydroxyethyl)piperazine, 1-[2-(2-hydroxyethoxy)ethyl]piperazine, piperidineethanol, 1-(2-hydroxyethyl)pyrrolidine, 1-(2-hydroxyethyl)-2-pyrrolidinone, 3-piperidino-1,2-propanediol, 3-pyrrolidino-1,2-propanediol, 8-hydroxyeurolidine, 3-quinuclidinol, 3-tropanol, 1-methyl-2-pyrrolidineethanol, 1-aziridineethanol, N-(2-hydroxyethyl)phthalimide, N-(2-hydroxyethyl)isonicotinamide, etc.

The amide derivatives can include formamide, N-methylformamide, N,N-dimethylformamide, acetamide, N-methylacetamide, N,N-dimethylacetamide, propionamide, benzamide, etc.

The imide derivatives can include phthalimide, succinimide, maleimide, etc.

It is possible to use compounds represented by the following formula (E1) for the quencher.

(R³⁰¹)_{w}-N-(R³⁰²)_{3-w} (E1)

In the formula (E1), "w" represents 1, 2, or 3. R³⁰¹ is any substituent selected form the group consisting of substituents represented by the following formulae (E2) to (E4). R³⁰² is a hydrogen atom or an alkyl group having 1 to 20 carbon atoms, and may have an ether bond or a hydroxy group. When two or more R³⁰¹ exist, two R³⁰¹ may bond each other to form a ring with a nitrogen atom bonded with R³⁰¹. When two or more R³⁰¹ exist, these may be the same or different. When two or more R³⁰² exist, these may be the same or different.

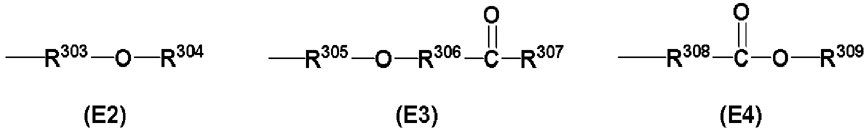

In the formulae (E2) to (E4), R³⁰³, R³⁰⁵, and R³⁰⁸ are each independently a linear or branched alkanediyl group having 1 to 4 carbon atoms. R³⁰⁴ and R³⁰⁷ are each independently a hydrogen atom or an alkyl group having 1 to 20 carbon atoms, and may have at least one selected from the group consisting of a hydroxy group, an ether bond, an ester bond, and a lactone ring. R³⁰⁶ is a single bond, or a linear or branched alkanediyl group having 1 to 4 carbon atoms. R³⁰¹ is an alkyl group having 1 to 20 carbon atoms, and may have at least one selected from the group consisting of a hydroxy group, an ether bond, an ester bond, and a lactone ring.

The compounds represented by the formula (E1) include, but is not limited to, tris[2-(methoxymethoxy)ethyl]amine, tris[2-(2-methoxyethoxy)ethyl]amine, tris[2-(2-methoxyethoxymethoxy)ethyl]amine, tris[2-(1-methoxyethoxy)ethyl]amine, tris[2-(1-ethoxyethoxy)ethyl]amine, tris[2-(1-ethoxypropoxy)ethyl]amine, tris[2-{2-(2-hydroxyethoxy)ethoxy}ethyl]amine, 4,7,13,16,21,24-hexaoxa-1,10-diazabicyclo[8.8.8]hexacosane, 4,7,13,18-tetraoxa-1,10-diazabicyclo[8.5.5]eicosane, 1,4,10,13-tetraoxa-7,16-diazabicyclooctadecane, 1-aza-12-crown-4, 1-aza-15-crown-5, 1-aza-18-crown-6, tris(2-formyloxyethyl)amine, tris(2-acetoxyethyl)amine, tris(2-propionyloxyethyl)amine, tris(2-butyryloxyethyl)amine, tris(2-isobutyryl)oxyethyl)amine, tris(2-valeryloxyethyl)amine, tris(2-pivaloyloxyethyl)amine, N,N-bis(2-acetoxyethyl)2-(acetoxyacetoxy)ethylamine, tris(2-methoxycarbonyloxyethyl)amine, tris(2-tert-butoxycarbonyloxyethyl)amine, tris[2-(2-oxopropoxy)ethyl]amine, tris[2-(methoxycarbonylmethyl)oxyethyl]amine, tris[2-(tert-butoxycarbonylmethyloxy)ethyl]amine, tris[2-(cyclohexyloxycarbonylmethyloxy)ethyl]amine, tris(2-methoxycarbonylethyl)amine, tris(2-ethoxycarbonylethyl)amine, N,N-bis(2-hydroxyethyl)-2-(methoxycarbonyl)ethylamine, N,N-bis(2-acetoxyethyl)-2-(methoxycarbonyl)ethylamine, N,N-bis(2-hydroxyethyl)-2-(ethoxycarbonyl)ethylamine, N,N-bis(2-acetoxyethyl)-2-(ethoxycarbonyl)ethylamine, N,N-bis(2-hydroxyethyl)-2-(2-methoxyethoxycarbonyl)ethylamine, N,N-bis(2-acetoxyethyl)-2-(2-methoxyethoxycarbonyl)ethylamine, N,N-bis(2-hydroxyethyl)-2-(2-hydroxyethoxycarbonyl)ethylamine, N,N-bis(2-acetoxyethyl)-2-(2-acetoxyethoxycarbonyl)ethylamine, N,N-bis(2-hydroxyethyl)-2-[(methoxycarbonyl)methoxycarbonyl]ethylamine, N,N - bis(2-acetoxyethyl)-2-[(methoxycarbonyl)methoxycarbonyl]ethylamine, N,N-bis(2-hydroxyethyl)-2-(2-oxopropoxycarbonyl)ethylamine, N,N-bis(2-acetoxyethyl)-2-(2-oxopropoxycarbonyl)ethylamine, N,N-bis(2-hydroxyethyl)-2-(tetrahydrofurfuryloxycarbonyl)ethylamine, N,N-bis(2-acetoxyethyl)-2-(tetrahydrofurfuryloxycarbonyl)ethylamine, N,N-bis(2-hydroxyethyl)-2-[(2-oxotetrahydrofuran-3-yl)oxycarbonyl]ethylamine, N,N-bis(2-acetoxyethyl)-2-[(2-oxotetrahydrofuran-3-yl)oxycarbonyl]ethylamine, N,N-bis(2-hydroxyethyl)-2-(4-hydroxybutoxycarbonyl)ethylamine, N,N-bis(2-formyloxyethyl)-2-(4-formyloxybutoxycarbonyl)ethylamine, N,N-bis(2-formyloxyethyl)-2-(2-formyloxyethoxycarbonyl)ethylamine, N,N-bis(2-methoxyethyl)-2-(methoxycarbonyl)ethylamine, N-(2-hydroxyethyl)bis[2-(methoxycarbonyl)ethyl]amine, N-(2-acetoxyethyl)bis[2-(methoxycarbonyl)ethyl]amine, N-(2-hydroxyethyl)bis[2-(ethoxycarbonyl)ethyl]amine, N-(2-acetoxyethyl)bis[2-(ethoxycarbonyl)ethyl]amine, N-(3-hydroxy-1-propyl)bis[2-(methoxycarbonyl)ethyl]amine, N-(3-acetoxy-1-propyl)bis[2-(methoxycarbonyl)ethyl]amine, N-(2-methoxyethyl)bis[2-(methoxycarbonyl)ethyl]amine, N-butylbis[2-(methoxycarbonyl)ethyl]amine, N-butylbis[2-(2-methoxyethoxycarbonyl)ethyl]amine, N-methylbis(2-acetoxyethyl)amine, N-ethylbis(2-acetoxyethyl)amine, N-methylbis(2-pivaloyloxyethyl)amine, N-ethylbis[2-(methoxycarbonyloxy)ethyl]amine, N-ethylbis[2-(tert-butoxycarbonyloxy)ethyl]amine, tris(methoxycarbonylmethyl)amine, tris(ethoxycarbonylmethyl)amine, N-butylbis(methoxycarbonylmethyl)amine, N-hexylbis(methoxycarbonylmethyl)amine, and β-(diethylamino)-δ-valerolactone.

Content amount of component (E) is 0 to 3 parts by mass based on 100 parts by mass of component (A). When containing component (E), in terms of sensitivity, its content amount is preferably 0.01 to 2 parts by mass, more preferably 0.05 to 1 parts by mass. Component (E) can be used solely or in combination of two kinds or more.

### [(F) Antioxidant]

The photosensitive resin composition of the present invention may further include an antioxidant as component (F). By including component (F) an antioxidant, it is possible to improve heat-resistance and makes it easier to obtain transparency of a photosensitive resin composition. The antioxidant can include a hindered phenolic compound, ammonia, primary aliphatic amines, a hindered amine compound, etc.

The hindered phenolic compounds are not particularly limited, but the following are preferable. Examples include, 1,3,5-trimethyl-2,4,6-tris(3,5-di-tert-butyl-4-hydroxybenzyl)benzene (product name: Irganox 1330), 2,6-di-tert-butyl-4-methylphenol (product name: Sumilizer BHT), 2,5-di-tert-butyl-hydroquinone (product name: Nocrac NS-7), 2,6-di-tert-butyl-4-ethylphenol (Product name: Nocrac M-17), 2,5-di-tert-pentylhydroquinone (Product name: Nocrac DAH), 2,2'-methylenebis(4-methyl-6-tert-butylphenol) (Product name: Nocrac NS -6), 3,5-di-tert-butyl-4-hydroxybenzylphosphonate-diethyl ester (product name: Irganox 1222), 4,4'-thiobis(3-methyl-6-tert-butylphenol) (Product name: Nocrac 300), 2,2'-methylenebis(4-ethyl-6-tert-butylphenol) (Product name: Nocrac NS-5), 4,4'-butylidenebis(3-methyl-6-tert-butylphenol) (product name: ADK STAB AO-40), 2-tert-butyl-6-(3-tert-butyl-2-hydroxy-5-methylbenzyl)-4-methylphenylacrylate (product name: Sumilizer GM), 2-[1-(2-hydroxy-3,5-di-tert-pentylphenyl)ethyl]-4,6-di-tert-pentylphenyl acrylate (product name: Sumilizer GS), 2,2'-methylenebis[4-methyl-6-(α-methyl-cyclohexyl)phenol], 4,4'-methylenebis(2,6-di-tert-butylphenol) (product name: SEENOX 226M), 4,6-bis(octylthiomethyl)-o-cresol (product name: Irganox 1520L), 2,2'-ethylenebis(4,6-di-tertbutylphenol), octadecyl-3-(3,5-di-tert-butyl-4-hydroxyphenyl)propionate (product name: Irganox 1076), 1,1,3-tris-(2-methyl-4-hydroxy-5-tert-butylphenyl)butane (product name: ADK STAB AO-30), tetrakis[methylene-(3,5-di-tert-butyl-4-hydroxyhydrocinnamate)]methane (product name: ADK STAB AO-60), triethylene glycol bis[3-(3-tert-butyl-5-methyl-4-hydroxyphenyl)propionate] (product name: Irganox 245), 2,4-bis-(n-octylthio)-6-(4-hydroxy-3,5-di-tert-butylanilino)-1,3,5-triazine (product name: Irganox 565), N,N'-hexamethylenebis(3,5-di-tert-butyl-4-hydroxy-hydrocinnamamide) (product name: Irganox 1098), 1,6-hexanediol-bis[3-(3,5-di-tert-butyl-4-hydroxyphenyl)propionate] (product name: Irganox 259), 2,2-thio-diethylenebis[3-(3,5-di-tert-butyl-4-hydroxyphenyl)propionate] (product name: Irganox 1035), 3,9-bis[2-[3-(3-tert-butyl-4-hydroxy-5-methylphenyl)propionyloxy]1,1-dimethylethyl]2,4,8,10-tetraoxaspiro[5.5]undecane (product name: Sumilizer GA-80), tris-(3,5-di-tert-butyl-4-hydroxybenzyl)isocyanurate (product name: Irganox 3114), bis(3,5-di-tert-butyl-4-hydroxybenzylethylphosphonate) calcium/polyethylene wax mixture (50:50) (product name: Irganox 1425WL), isooctyl-3-(3,5-di-tert-butyl-4-hydroxyphenyl)propionate (product name: Irganox 1135), 4,4'-thiobis(6-tert-butyl-3-methylphenol) (product name: Sumilizer WX-R), 6-[3-(3-tert-butyl-4-hydroxy-5-methylphenyl)propoxy]-2,4,8,10-tetra-tert-butyldibenz[d,f][1,3,2]dioxaphosphepine (product name: Sumilizer GP), etc.

The primary aliphatic amines can include methylamine, ethylamine, n-propylamine, isopropylamine, n-butylamine, isobutylamine, sec-butylamine, tert-butylamine, pentylamine, tert-pentylamine, cyclopentylamine, hexylamine, cyclohexylamine, heptylamine, octylamine, nonylamine, decylamine, dodecylamine, cetylamine, methylenediamine, ethylenediamine, tetraethylenepentamine, etc.

The hindered amine compounds are not particularly limited, but the following are preferable. Examples include, p,p'-dioctyldiphenylamine (product name: Irganox 5057), phenyl-α-naphthylamine (product name: Nocrac PA), poly(2,2,4-trimethyl-1,2-dihydroquinoline) (product name : Nocrac 224, 224-S), 6-ethoxy-2,2,4-trimethyl-1,2-dihydroquinoline (product name: Nocrac AW), N,N'-diphenyl-p-phenylenediamine (product name: Nocrac DP), N,N'-di-β-naphthyl-p-phenylenediamine (product name: Nocrac White), N-phenyl-N'-isopropyl-p-phenylenediamine (product name: Nocrac 810NA), N, N'-diallyl-p-phenylenediamine (product name: Nonflex TP), 4,4'-(α,α-dimethylbenzyl)diphenylamine (product name: Nocrac CD), p,p-toluenesulfonylaminodiphenylamine (product name : Nocrac TD), N-phenyl-N'-(3-methacryloyloxy-2-hydroxypropyl)-p-phenylenediamine (product name: Nocrac G1), N-(1-methylheptyl)-N'-phenyl-p-phenylenediamine (product name: Ozonon 35), N,N'-di-sec-butyl-p-phenylenediamine (product name: Sumilizer BPA), N-phenyl-N'-1,3-dimethylbutyl-p-phenylenediamine (product name: Antigene 6C), alkylated diphenylamine (product name: Sumilizer 9A), dimethyl succinate-1-(2-hydroxyethyl)-4-hydroxy-2,2,6,6-tetramethylpiperidine polycondensate (product name: Tinuvin 622LD), poly[[6-(1,1,3,3-tetramethylbutyl)amino-1,3,5-triazine-2,4-diyl][(2,2,6,6-tetramethyl-4-piperidyl)imino]hexamethylene[(2,2,6,6-tetramethyl-4-piperidyl)imino]] (product name: CHIMASSORB 944), N,N'-bis(3-aminopropyl)ethylenediamine-2,4-bis[N-butyl-N-(1,2,2,6,6-pentamethyl-4-piperidyl)amino]-6-chloro-1,3,5-triazine condensate (product name: CHIMASSORB 119FL), bis(1-octyloxy-2,2,6,6-tetramethyl-4-piperidyl) sebacate (product name: TINUVIN 123), bis(2,2,6,6-tetramethyl-4-piperidyl) sebacate (product name: TINUVIN 770), bis(1,2,2,6,6-pentamethyl-4-piperidyl)-2-(3,5-di-tert-butyl-4-hydroxybenzyl)-2-n-butylmalonate (product name: TINUVIN 144), bis(1,2,2,6,6-pentamethyl-4-piperidyl) sebacate (product name: TINUVIN 765), tetrakis(1,2,2,6,6-pentamethyl-4-piperidyl)1,2,3,4-butanetetracarboxylate (product name: LA-57), tetrakis(2,2,6,6-tetramethyl-4-piperidyl)1,2,3,4-butanetetracarboxylate (product name: LA-52), a mixed esterified product of 1,2,3,4-butanetetracarboxylic acid, 1,2,2,6,6-pentamethyl-4-piperidinol, and 1-tridecanol (product name: LA-62), a mixed esterified product of 1,2,3,4-butanetetracarboxylic acid, 2,2,6,6-tetramethyl-4-piperidinol, and 1-tridecanol (product name: LA-67), a mixed esterified product of 1,2,3,4-butanetetracarboxylic acid, 1,2,2,6,6-pentamethyl-4-piperidinol, and 3,9-bis(2-hydroxy-1,1-dimethylethyl)-2,4,8,10-tetraoxaspiro[5.5]undecane (product name: LA-63P), a mixed esterified product of 1,2,3,4-butanetetracarboxylic acid, 2,2,6,6-tetramethyl-4-piperidinol, and 3,9-bis(2-hydroxy-1,1-dimethylethyl)-2,4,8,10-tetraoxaspiro[5.5]undecane (product name: LA-68LD), (2,2,6,6-tetramethylene-4-piperidyl)-2-propylenecarboxylate (product name: ADK STAB LA-82), (1,2,2,6,6-pentamethyl-4-piperidyl)-2-propylenecarboxylate (product name: ADK STAB LA-87), etc.

Content amount of component (F) is not particularly limited, but the content amount is preferably 0.01 to 1 mass% in the photosensitive resin layer used in the present invention, when component (F) is contained.

The photosensitive resin composition used in the present invention, can be prepared by conventional methods. For example, the photosensitive resin composition used in the present invention can be prepared by stirring and mixing the components and then filtering as needed. The photosensitive resin layer can be formed by coating the photosensitive resin composition.

The photosensitive resin composition used in the present invention, can be used suitably for material for a protective film for a semiconductor element, a protective film for wiring, coverlay film, solder mask, insulating film for through electrodes (for TSVs), and further for adhesives between laminated substrates in three-dimensional lamination.

Viscosity of the photosensitive resin composition used in the present invention is preferably 50 mPa·s or more and not more than 1500 mPa·s. It is more preferable 150 mPa·s or more and not more than 1000 mPa·s because flatness of the film is excellent and sufficient thickness of the film can be secured even on a step. In the present invention, viscosity is measured by a cone-plate rotational viscometer at 25°C.

The film on the step can be coated with arbitrary thickness by adjusting amount of solvent in the photosensitive resin composition used for the present invention and rotational rate in coating.

### (Semiconductor Substrate)

The semiconductor substrate has a stepped surface on one side, and is a semiconductor substrate having concavity and convexity. For example, the semiconductor substrate has preferably either or both of a groove and a hole, which has a width of 10 to 100 um and a depth of 10 to 120 um. A laminate on which the photosensitive resin layer is formed may have a slope. It gives an excellent contact between a semiconductor substrate and a photosensitive resin layer and high-level flatness.

As described before, in the inventive laminate, a photosensitive resin layer is formed after a pre-wetting solvent is coated on a semiconductor substrate in advance. Therefore, there is no homogeneous dispersion between pre-wetting solvent and a solvent of the photosensitive resin composition, and a concentration gradient with a higher solvent concentration on the semiconductor substrate side can also be obtained.

### [Patterning Method]

The inventive patterning method, in the laminate produced according to above manufacturing method, includes: curing the photosensitive resin layer by pre-heating to cure a photosensitive resin film; exposing the photosensitive resin film through a photomask; and developing with a developing solution and removing an unexposed part by dissolving after heating after exposing, to form a pattern.

A step of curing the photosensitive resin layer by pre-heating to form a photosensitive resin film is a step to form a photosensitive resin film on a semiconductor substrate with use of a photosensitive resin composition. The semiconductor substrate can include a silicon wafer, a silicon wafer for through electrodes, a silicon wafer made into a thin film by back polishing, a plastic or ceramic substrate, a substrate which has metals such as Ni and Au on the entire surface or a part of the substrate by ion sputtering method, plating method, etc. It is also possible to use the semiconductor substrate having either or both of a groove and a hole, which has a width of 10 to 100 um and a depth of 10 to 120 um. A width and a depth of the groove or the hole of a semiconductor substrate can be measured by a scanning electron microscope.

A method for forming the photosensitive resin film includes, for example, spin-coating a photosensitive resin composition on a semiconductor substrate and pre-heating (prebaking: PB) as occasion demands for efficient photocuring reaction. The pre-heating can be performed, for example, at 40 to 140°C for 1 minute to 1 hour.

Amount of coating of photosensitive resin composition can be determined according to the intended use, but its thickness is preferably 0.1 to 200 um, more preferably 1 to 150 um.

Next, the photosensitive resin film is exposed through a photomask. The exposure is preferably performed by light having a wavelength of 1 to 600 nm, more preferably 10 to 600 nm, and further preferably 190 to 500 nm. The light having such wavelengths includes, for example, light having a variety of wavelength, generated by a radiation generator, such as ultraviolet light such as g-ray, h-ray, i-ray, far ultraviolet light (248nm, 193nm), etc. Among these, light having a wavelength of 248 to 436 nm is especially preferable. The exposure is preferably 10 to 10,000 mJ/cm².

The exposure may be performed though a photomask. The photomask may be one in which a desired pattern is hollowed out, for example. Material for the photomask is not particularly limited, but preferably can shield the light having the aforementioned wavelength. For example, a shielding film containing chromium is preferably used.

Further, a post exposure baking (PEB) may be performed, in order to enhance development sensitivity. PEB is preferable at 40 to 150°C for 0.5 to 10 minutes. By PEB, exposed part is crosslinked to form an insoluble pattern which cannot be dissolved by solvent that is a developing solution.

After exposure or PEB, an unexposed part is removed with dissolving by developing with a developing solution to form a pattern. The developing solution is preferably alcohols such as isopropyl alcohol (IPA), ketones such as cyclohexanone, glycols such as PGME, etc., but a solvent used for the photosensitive resin composition can be used also. A method for developing can include a conventional method such as immersing a patterned substrate in the developing solution. Thereafter, by washing, rinsing, drying, etc., as occasion demands, a photosensitive resin film having a desired pattern can be obtained.

Further, the film having a desired pattern formed is preferably subjected to postcure at 100 to 250°C, preferably at 150 to 220°C, using an oven or a hot-plate. When the temperature of the postcure is 100 to 250°C, crosslink density of a photosensitive resin film is increased, a residual volatile component can be removed, and it is more preferable in terms of adhesiveness to a substrate, heat-resistance, durability, electrical properties, and adhesive strength. Time for the postcure is preferably 10 minutes to 10 hours, more preferably 10 minutes to 3 hours. Using the inventive photosensitive resin composition, a coating film having excellence in variety of film properties can be obtained even if the postcure is performed at relative low temperature around 200°C. Thickness of the coating film (cured film) after postcure is usually 1 to 200 um, preferably 5 to 50 um.

When pattering is not necessary, for example, in case that a simple uniform coating film is desired, forming a coating film may be exposing to light having appropriate wavelength without using a photomask in the exposing step.

### EXAMPLE

Hereinafter, the present invention will be specifically described with reference to Synthesis Examples, Comparative Synthesis Examples, Examples and Comparative Examples. However, the present invention is not limited thereto.

In the following Synthesis Examples, Mw of each resin was measured by GPC using monodisperse polystyrene as the standard under the following analytical conditions: flow rate of 0.6 mL/min, tetrahydrofuran for elution solvent, and column temperature of 40°C, using TSKgel Super HZM-H (Tosoh Corporation) as the column.

Compounds (S-1) to (S-6) used in the following Synthesis Examples are as follows.

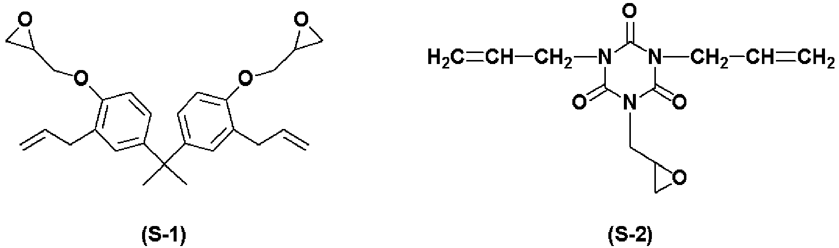

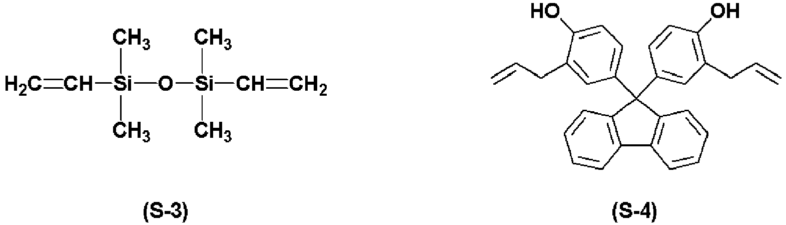

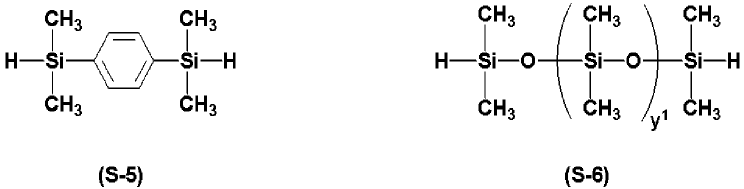

### [1] Synthesis of a polymer having a silicone skeleton [Synthesis Example 1] Synthesis of silicone resin 1

117.6 g (0.28 mol) of compound (S-1), 79.5 g (0.3 mol) of compound (S-2), and 80.0 g (0.43 mol) of compound (S-3) were added to a 3 L flask equipped with a stirrer, a thermometer, a nitrogen purging device, and a reflux condenser, then 2,000 g of toluene was added and the mixture was heated to 70°C. Then 1.0 g of toluene solution of platinic chloride (platinum concentration 0.5 mass%) was added, and 67.9 g (0.35 mol) of compound (S-5) and 399.8 (0.65 mol) of compound (S-6) (y¹=8) were added dropwise over 1 hour (total hydrosilyl group / total alkenyl group = 1.01/1.0 (molar ratio)). After completion of the drop, the mixture was heated to 100°C and aged for 6 hours, and toluene was removed from the reaction solution under reduced pressure to obtain silicone resin 1. Silicone resin 1 was confirmed to contain repeating units a1, b1, a3, b3, a4, and b4 by ¹H-NMR (made by Bruker Corporation). The Mw of silicone resin 1 was 28,000 and the silicone content ratio was 64.4 mass%.

### [Synthesis Example 2] Synthesis of silicone resin 2

90.1 g (0.34 mol) of compound (S-2), 223.6 g (0.52 mol) of compound (S-4), and 27.9 g (0.15 mol) of compound (S-3) were added to a 3 L flask equipped with a stirrer, a thermometer, a nitrogen purging device, and a reflux condenser, then 2,000 g of toluene was added and the mixture was heated to 70°C. Then 1.0 g of toluene solution of platinic chloride (platinum concentration 0.5 mass%) was added, and 38.8 g (0.2 mol) of compound (S-5) and 492.0 g (0.8 mol) of compound (S-6) (y¹=8) were added dropwise over 1 hour (total hydrosilyl group / total alkenyl group = 1/1.0 (molar ratio)). After completion of the drop, the mixture was heated to 100°C and aged for 6 hours, and toluene was removed from the reaction solution under reduced pressure to obtain silicone resin 2. Silicone resin 2 was confirmed to contain repeating units a2, b2, a3, b3, a4, and b4 by ¹H-NMR (made by Bruker Corporation). The Mw of silicone resin 2 was 32,000 and the silicone content ratio was 59.6 mass%.

### [Synthesis Example 3] Synthesis of silicone resin 3

201.6 g (0.48 mol) of compound (S-1), and 227.9 g (0.53 mol) of compound (S-4) were added to a 3 L flask equipped with a stirrer, a thermometer, a nitrogen purging device, and a reflux condenser, then 2,000 g of toluene was added and the mixture was heated to 70°C. Then 1.0 g of toluene solution of platinic chloride (platinum concentration 0.5 mass%) was added, and 155.2 g (0.80 mol) of compound (S-5) and 589.2 g (0.2mol) of compound (S-6) (y¹=38) were added dropwise over 1 hour (total hydrosilyl group / total alkenyl group = 1/1.01 (molar ratio)). After completion of the drop, the mixture was heated to 100°C and aged for 6 hours, and toluene was removed from the reaction solution under reduced pressure to obtain silicone resin 3. Silicone resin 3 was confirmed to contain repeating units a1, b1, a2, and b2 by ¹H-NMR (made by Bruker Corporation). The Mw of silicone resin 3 was 25,000 and the silicone content ratio was 50.2 mass%.

### [Synthesis Example 4] Synthesis of silicone resin 4

63.0 g (0.15 mol) of compound (S-1), 74.2 g (0.28 mol) of compound (S-2), 150.5 g (0.35 mol) of compound (S-4), and 42.8 g (0.23mol) of compound (S-3) were added to a 3 L flask equipped with a stirrer, a thermometer, a nitrogen purging device, and a reflux condenser, then 2,000 g of toluene was added and the mixture was heated to 70°C. Then 1.0 g of toluene solution of platinic chloride (platinum concentration 0.5 mass%) was added, and 58.2 g (0.3 mol) of compound (S-5) and 289.1 g (0.47mol) of compound (S-6) (y¹=8) were added dropwise over 1 hour (total hydrosilyl group / total alkenyl group = 1/1.01 (molar ratio)). After completion of the drop, the mixture was heated to 100°C and aged for 6 hours, and toluene was removed from the reaction solution under reduced pressure to obtain silicone resin 4. Silicone resin 4 was confirmed to contain repeating units a1, b1, a2, b2, a3, b3, a4, and b4 by ¹H-NMR (made by Bruker Corporation). The Mw of silicone resin 4 was 23,000, and the silicone content ratio was 50.0 mass%.

### [3] Preparation of photosensitive resin composition [Compositions 1-1 to 1-7]

Components each are blended according to blended amounts described in Tables 1 and 2, and the mixture was stirred, mixed, and dissolved at a normal temperature. Then, the mixture was subjected to precision filtration with 1.0 um Teflon (registered trademark) filter to obtain photosensitive resin compositions 1-1 to 1-7.

**[Table 1]**

| | | Composition | | | |
|---|---|---|---|---|---|
| | | 1-1 | 1-2 | 1-3 | 1-4 |
| Polymer | Silicone resin 1 | 100 | | | |
| | Silicone resin 2 | | 100 | | |
| | Silicone resin 3 | | | 100 | |
| | Silicone resin 4 | | | | 100 |
| Photo-acid generator | PAG-1 | 1 | 1 | 1 | 1 |
| Crosslinking agent | CL-1 | 20 | 20 | 20 | 20 |
| Antioxidant | F-1 | 0.1 | 0.1 | 0.1 | 0.1 |
| | F-2 | 0.1 | 0.1 | 0.1 | 0.1 |
| Solvent | Cyclopentanone | 55 | 55 | 55 | 30 |
| | PGMEA | | | | 25 |
| Quencher | AM-1 | 0.3 | 0.3 | 0.3 | 0.3 |

**[Table 2]**

| | | Composition | | |
|---|---|---|---|---|
| | | 1-5 | 1-6 | 1-7 |
| Polymer | Acrylic resin 1 | 100 | | |
| | Acrylic resin 2 | | 100 | |
| | Acrylic resin 3 | | | 100 |
| Photopolymerization initiator | Irgasure OXE-01 | 1 | 1 | 1 |
| Crosslinking agent | CL-2 | 20 | 20 | 20 |
| Antioxidant | F-1 | | | 0.1 |
| | F-2 | | | 0.1 |
| Solvent | PGMEA | 55 | 55 | 55 |

Acrylic resin 1 to 3, a photo-acid generator PAG-1, a photopolymerization initiator, crosslinking agents CL-1 and CL-2, antioxidants F-1 and F-2, and a quencher AM-1, which described in Tables 1 and 2, are as follows.
·Acrylic resin 1: ART CURE MAP-4050 (made by Negami Chemical Industrial Co., Ltd.)
·Acrylic resin 2: ART CURE MAP-2801 (made by Negami Chemical Industrial Co., Ltd.)
·Acrylic resin 3: PHORET ZAH-106 (made by Soken Chemical & Engineering Co., Ltd.)

### ·PAG-1

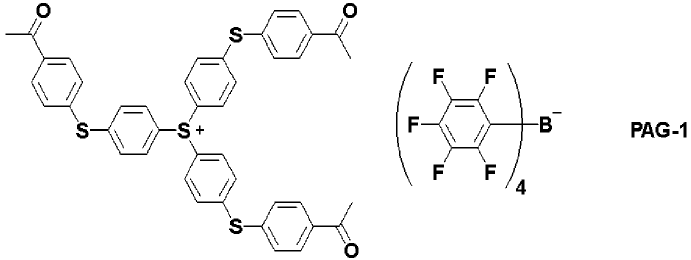

### ·Photopolymerization initiator: Irgacure OXE01: made by BASF Japan Ltd.

### ·CL-1

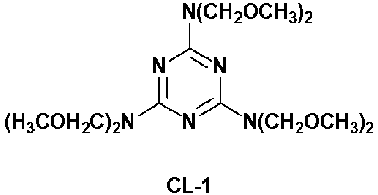

·CL-2 KAYARAD GPO-303 (made by NIPPON KAYAKU CO., LTD.)
·F-1: CHIMASSORB 119FL (made by BASF)
·F-2: Irganox 3114 (made by BASF)

### ·AM-1

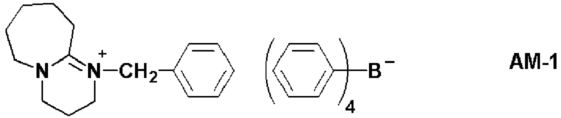

### [4] Evaluation of embedding step

In the present Example, a substrate with a step having an opening width of 70 um and an opening depth of 80 um is prepared for each of 3 kinds of substrates, a Si substrate, Ti/Cu substrate, and SiO₂ substrate.

After pre-wetting step where a pre-wetting solvent is dropped on entire surface of a stepped substrate, 5 ml of each composition is dropped for embedding.

For conditions for spin-coating, FIG. 3 is referred to. For rotation time, T1 to T2 is 300 seconds, T2 to T3 is 0.5 seconds, T4 to T5 is 8 seconds, and T5 to T6 is 15 seconds. For rotational rate, S1 is 20 rpm, S2 is 100 rpm, and S3 is 300 rpm.

After completion of embedding, the substrate is heated at 120°C for 300 seconds by a hot-plate for removing solvents and drying.

In the present Examples, a film thickness of a dried laminate on the substrate is 20 um as a target.

Tables 3 to 7 show Examples where embedding using compositions 1-1 to 1-7 is performed according to the above method and Comparative Examples where embedding is performed without pre-wetting or scraping step. Three types of pre-wetting solvents were studied. These are cyclopentanone, a mixed solution of cyclopentanone : PGMEA = 50:50, and a mixed solution of cyclopentanone : ethyl lactate = 50:50. Note that the mixed ration is by mass.

### (1) Coatability

Coatablity on a wafer was evaluated at conditions where 5 ml of each composition is dropped. The coatability is determined as "Good" when the composition spread over wafer surface by the end of spin-coating after dropped, and the coatability is determined as "Poor" when the composition did not spread over wafer surface by the end of spin-coating. The results are shown in Tables 3 to 7.

### (2) Embedability

In substrate of the laminate produced in the present embodiment, a cross-sectional view of the step having an opening width of 70 um and an opening depth of 80 um was observed by a scanning electron microscope (SEM), and was evaluated in term of embedability. The embedability is determined as "Good" when the composition was coated all over the pre-baked wafer surface and was embedded neatly to the bottom of the step without any void after dropped, and the embedability is determined as "Poor" when the composition was not embedded. The results are shown in Tables 3 to 7.

### (3) Evaluation of flatness

In observation of the substrate by a scanning electron microscope (SEM), film thickness of the composition on the substrate was measured at location with a step and a location without step. The flatness is determined as "Good" when the difference in the thickness between the two location is within 2011 um, the flatness is determined as "Fair" when the difference in the thickness between the two location is 1 um or more and less than 2 um, and the flatness is determined as "Poor" when the difference in the thickness between the two location is 2 um or more. The results are shown in Tables 3 to 7.

### (4) Evaluation of patternability

Using substrates evaluated as "Good" in the evaluation (2), exposure was carried out using a contact aligner exposure equipment with 365 nm exposure conditions through a mask to form 60 um Via, leaving 5 um each on the left and right side walls within the step. After the exposure, the substrate was subjected to PEB at 140°C for 5 minutes by a hot-plate, cooling-down, and spray development using PGMEA for 540 seconds, to form a pattern.

Photosensitive resin film on which a pattern is formed according to the above method, was subjected to postcure, with purging nitrogen, at 180°C for 2 hours by an oven. Then, cross-sectional observation of the formed Via pattern of 60 um was carried out with using a scanning electron microscope (SEM). Based on the obtained cross-sectional photo, patternability is determined as "Excellent" when vertical opening is obtained to the bottom, "Good" when reverse tapered opening is obtained to the bottom, "Fair" when scum is observed at the bottom, and "Poor" when with failure of an opening. The results are shown in Tables 3 to 7.

**[Table 3]**

| Si substrate | Example | | | | | | | Comparative Example | | | | | |
|---|---|---|---|---|---|---|---|---|---|---|---|---|---|
| | 1 | 2 | 3 | 4 | 5 | 6 | 7 | 1 | 2 | 3 | 4 | 5 | 6 |
| Composition | 1-1 | 1-2 | 1-3 | 1-4 | 1-5 | 1-6 | 1-7 | 1-1 | 1-4 | 1-7 | 1-1 | 1-4 | 1-7 |
| Pre-wet (Cyclopentanone) | Performed | | | | | | | | | | Not performed | | |
| Scraping | Performed | | | | | | | Not performed | | | - | | |
| Coatability | Good | Good | Good | Good | Good | Good | Good | Good | Good | Good | Poor | Poor | Poor |
| Embedability | Good | Good | Good | Good | Good | Good | Good | Good | Good | Good | Poor | Poor | Poor |
| Flatness | Good | Good | Good | Good | Good | Fair | Good | Poor | Poor | Poor | - | - | - |
| Patternability | Excellent | Excellent | Good | Good | Good | Good | Good | Good | Good | Good | - | - | - |

**[Table 4]**

| Si substrate | Example | | | | | | | Comparative Example | | | | | |
|---|---|---|---|---|---|---|---|---|---|---|---|---|---|
| | 8 | 9 | 10 | 11 | 12 | 13 | 14 | 7 | 8 | 9 | 10 | 11 | 12 |
| Composition | 1-1 | 1-2 | 1-3 | 1-4 | 1-5 | 1-6 | 1-7 | 1-1 | 1-4 | 1-7 | 1-1 | 1-4 | 1-7 |
| Pre-wet (Mixed solvent: Cyclopentanone, PGMEA) | Performed | | | | | | | | | | Not performed | | |
| Scraping | Performed | | | | | | | Not performed | | | - | | |
| Coatability | Good | Good | Good | Good | Good | Good | Good | Good | Good | Good | Poor | Poor | Poor |
| Embedability | Good | Good | Good | Good | Good | Good | Good | Good | Good | Good | Poor | Poor | Poor |
| Flatness | Good | Good | Fair | Good | Good | Good | Good | Poor | Poor | Poor | - | - | - |
| Patternability | Excellent | Excellent | Good | Good | Good | Excellent | Excellent | Good | Good | Good | - | - | - |

**[Table 5]**

| Si substrate | Example | | | | | | | Comparative Example | | | | | |
|---|---|---|---|---|---|---|---|---|---|---|---|---|---|
| | 15 | 16 | 17 | 18 | 19 | 20 | 21 | 13 | 14 | 15 | 16 | 17 | 18 |
| Composition | 1-1 | 1-2 | 1-3 | 1-4 | 1-5 | 1-6 | 1-7 | 1-1 | 1-4 | 1-7 | 1-1 | 1-4 | 1-7 |
| Pre-wet (Mixed solvent: Cyclopentanone, Ethyl lactate) | Performed | | | | | | | | | | Not performed | | |
| Scraping | Performed | | | | | | | Not performed | | | - | | |
| Coatability | Good | Good | Good | Good | Good | Good | Good | Good | Good | Good | Poor | Poor | Poor |
| Embedability | Good | Good | Good | Good | Good | Good | Good | Good | Good | Good | Poor | Poor | Poor |
| Flatness | Good | Good | Good | Fair | Good | Good | Good | Poor | Poor | Poor | - | - | - |
| Patternability | Excellent | Excellent | Good | Good | Good | Excellent | Excellent | Good | Good | Good | - | - | - |

**[Table 6]**

| Ti/Cu substrate | Example | | | | | | | Comparative Example | | | | | |
|---|---|---|---|---|---|---|---|---|---|---|---|---|---|
| | 22 | 23 | 24 | 25 | 26 | 27 | 28 | 19 | 20 | 21 | 22 | 23 | 24 |
| Composition | 1-1 | 1-2 | 1-3 | 1-4 | 1-5 | 1-6 | 1-7 | 1-1 | 1-4 | 1-7 | 1-1 | 1-4 | 1-7 |
| Pre-wet (Cyclopentanone) | Performed | | | | | | | | | | Not performed | | |
| Scraping | Performed | | | | | | | Not performed | | | - | - | - |
| Coatability | Good | Good | Good | Good | Good | Good | Good | Good | Good | Good | Poor | Poor | Poor |
| Embedability | Good | Good | Good | Good | Good | Good | Good | Good | Good | Good | Poor | Poor | Poor |
| Flatness | Good | Good | Good | Good | Good | Good | Good | Poor | Poor | Poor | - | - | - |
| Patternability | Good | Excellent | Good | Good | Good | Fair | Good | Good | Fair | Good | - | - | - |

**[Table 7]**

| SiO₂ substrate | Example | | | | | | | Comparative Example | | | | | |
|---|---|---|---|---|---|---|---|---|---|---|---|---|---|
| | 29 | 30 | 31 | 32 | 33 | 34 | 35 | 25 | 26 | 27 | 28 | 29 | 30 |
| Composition | 1-1 | 1-2 | 1-3 | 1-4 | 1-5 | 1-6 | 1-7 | 1-1 | 1-4 | 1-7 | 1-1 | 1-4 | 1-7 |
| Pre-wet (Cyclopentanone) | Performed | | | | | | | | | | Not performed | | |
| Scraping | Performed | | | | | | | Not performed | | | - | - | - |
| Coatability | Good | Good | Good | Good | Good | Good | Good | Fair | Fair | Fair | Poor | Poor | Poor |
| Embedability | Good | Good | Good | Good | Good | Good | Good | Good | Good | Good | Poor | Poor | Poor |
| Flatness | Good | Good | Good | Good | Good | Good | Good | Poor | Poor | Poor | - | - | - |
| Patternability | Good | Excellent | Good | Good | Good | Fair | Good | Good | Fair | Good | - | - | - |

In view of the foregoing, as Example 1 to 35 indicates, when used a laminate including a semiconductor substrate and a photosensitive resin layer formed on the semiconductor substrate, wherein the photosensitive resin layer contains resin having a silicone skeleton or acrylic resin, and the semiconductor substrate has a stepped surface on one side, a recessed portion formed by the stepped surface is filled with a pre-wetting solvent, and the photosensitive resin layer is formed thereon, it was found that a semiconductor substrate having the stepped surface can have excellent embedability by pre-wetting with saving solutions, and film with excellent flatness.

On the other hand, in Comparative Examples 1 to 3, 7 to 9, 13 to 15, 19 to 21, and 25 to 27, where the scraping step was not performed, flatness was poor. Further, in Comparative Examples 4 to 6, 10 to 12, 16 to 18, 22 to 24, and 28 to 30, where the pre-wetting was not performed, coatability and embeddability were poor, and flatness and patternability could not be evaluated.

It should be noted that the present invention is not limited to the above-described embodiments. The above embodiments are just examples, and any examples that have substantially the same feature and demonstrate the same functions and effects as those in the technical concept disclosed in claims of the present invention are included in the technical scope of the present invention.

## Claims

1. A laminate comprising:
a semiconductor substrate; and
a photosensitive resin layer formed on the semiconductor substrate,
wherein the photosensitive resin layer comprises resin having a silicone skeleton or acrylic resin, the semiconductor substrate has a stepped surface on one side, a recessed portion formed by the stepped surface is filled with a pre-wetting solvent, and the photosensitive resin layer is formed thereon.

2. The laminate according to claim 1, wherein an opening on the stepped surface has a width of 10 to 100 um and a depth of 10 to 120 um.

3. The laminate according to claim 1 or 2, wherein the pre-wetting solvent is a solvent of one kind or a mixed solvent containing a solvent having a boiling point of 130°C or higher at least 30 mass%.

4. The laminate according to any one of claims 1 to 3, wherein the photosensitive resin layer comprises:
(A) a polymer having a silicone skeleton;
(B) a photo-acid generator which is decomposed by a light of 190 to 500 nm and generates an acid; and
(C) a solvent.

5. The laminate according to claim 4, wherein (A) the polymer having a silicone skeleton comprises at least one repeating unit represented by any of the following formulae (a1) to (a4) and at least one repeating unit represented by any of the following formulae (b1) to (b4), 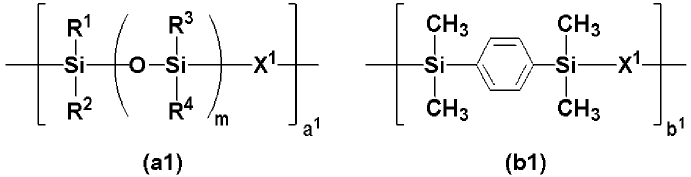 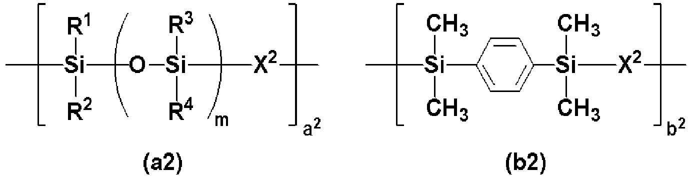 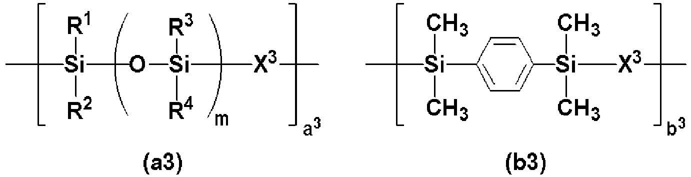 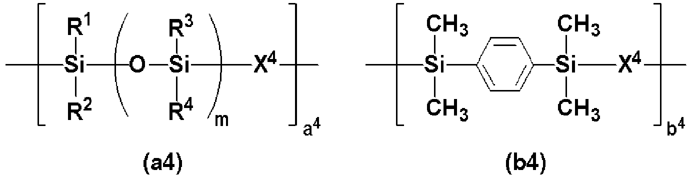
wherein, R¹ to R⁴ each independently represent a monovalent hydrocarbon group having 1 to 8 carbon atoms; "m" represents an integer of 1 to 600; a¹ to a⁴ and b¹ to b⁴ are values satisfying, 0≤a¹<1, 0≤a²<1, 0≤a³<1, 0≤a⁴<1, 0≤b¹<1, 0≤b²<1, 0≤b³<1, 0≤b⁴<1, 0<a¹+a²+a³+a⁴<1, 0<b²+b²+b³+b⁴<1, and a¹+a²+a³+a⁴+b¹+b²+b³+b⁴=1; X¹ is a divalent group represented by the following formula (X1); X² is a divalent group represented by the following formula (X2); X³ is a divalent group represented by the following formula (X3); X⁴ is a divalent group represented by the following formula (X4), 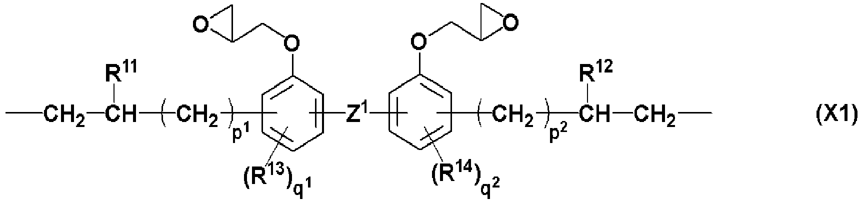
wherein, Z¹ represents a single bond, a methylene group, a propane-2,2-diyl group, a 1,1,1,3,3,3-hexafluoropropane-2,2-diyl group, or a fluorene-9,9-diyl group; R¹¹ and R¹² each independently represent a hydrogen atom or a methyl group; R¹³ and R¹⁴ each independently represent an alkyl group having 1 to 4 carbon atoms, or an alkoxy group having 1 to 4 carbon atoms; p¹ and p² each independently represent an integer of 0 to 7; q¹ and q² are each independently an integer of 0 to 2, 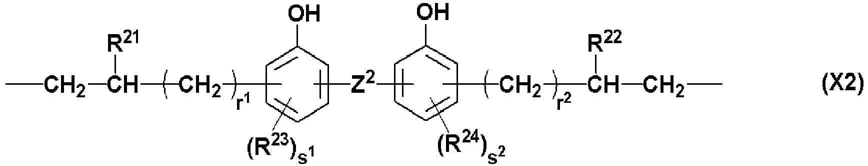
wherein, Z² represents a single bond, a methylene group, a propane-2,2-diyl group, a 1,1,1,3,3,3-hexafluoropropane-2,2-diyl group, or a fluorene-9,9-diyl group; R²¹ and R²² each independently represent a hydrogen atom or a methyl group; R²³ and R²⁴ each independently represent an alkyl group having 1 to 4 carbon atoms, or an alkoxy group having 1 to 4 carbon atoms; r¹ and r² each independently represent an integer of 0 to 7; s¹ and s² each independently represent an integer of 0 to 2, 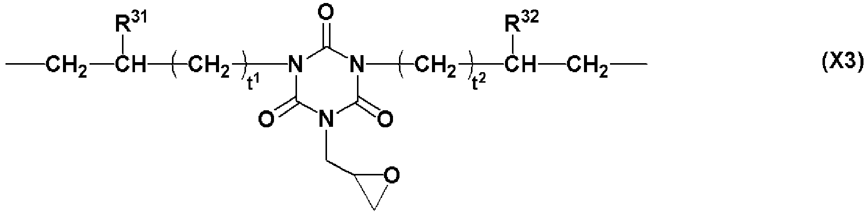
wherein, R³¹ and R³² each independently represent a hydrogen atom or a methyl group; t¹ and t² each independently represent an integer of 0 to 7, 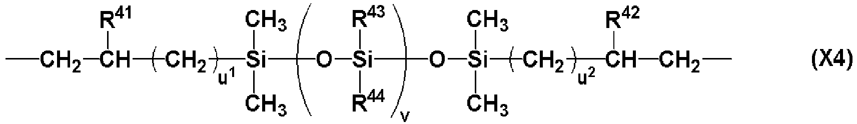
wherein, R⁴¹ and R⁴² each independently represent a hydrogen atom or a methyl group; R⁴³ and R⁴⁴ each independently represent a monovalent hydrocarbon group having 1 to 8 carbon atoms; u¹ and u² each independently represent an integer of 0 to 7; "v" represents an integer of 0 to 600.

6. The laminate according to any one of claims 1 to 3, wherein the photosensitive resin layer comprises:
(A') an acrylic polymer;
(B') a photopolymerization initiator; and
(C) a solvent.

7. A method for manufacturing a laminate, the method comprising:
a first coating step of pre-wetting a pre-wetting solvent on a recessed portion of a stepped surface of a semiconductor substrate having the stepped surface on one side by spin-coating, and filling the recessed portion of the stepped surface with the pre-wetting solvent;
a scraping step of scraping off any excess pre-wetting solvent pre-wetted on the semiconductor substrate, with spinning; and
a second coating step of spin-coating photosensitive resin composition comprising resin having silicone skeleton or acrylic resin, on a surface filled with the pre-wetting solvent by spin coating, to form a photosensitive resin layer, being coating film of the photosensitive resin composition.

8. The method for manufacturing a laminate according to claim 7, wherein the second coating step is performed with spinning the semiconductor substrate from the scraping step.

9. The method for manufacturing a laminate according to claim 7 or 8, wherein a kind of solvent or mixed solvents which comprise a solvent having a boiling point of 130°C or higher at least 30 mass% is used as a pre-wetting solvent used in the first coating step.

10. A patterning method for the laminate manufactured according to any one of claims 7 to 9, the patterning method comprising:
curing the photosensitive resin layer by pre-heating to form a photosensitive resin film;
exposing the photosensitive resin film through a photomask; and
developing with a developing solution and removing an unexposed part by dissolving after heating after exposing, to form a pattern.
